# EUROPEAN PATENT APPLICATION

(11) **EP 2 463 903 A1**
(43) Date of publication of application: **13.06.2012**
(21) Application number: 10806221.7
(22) Date of filing: 03.08.2010
(51) Int. Cl.: H01L 23/36, H01L 23/473, H05K 7/20

(54) **HEAT SINK**

(30) Priority: 07.08.2009 JP 2009184687
(71) Applicant: Furukawa-Sky Aluminium Corp., Chiyoda-ku Tokyo 101-8970 (JP)
(72) Inventor: HOSOKAWA, Toshiyuki, Tokyo 101-8970 (JP); UENO, Seizo, Tokyo 101-8970 (JP)
(74) Representative: Banse, Klaus-Dieter
(86) International application number: PCT/JP2010/004876
(87) International publication number: WO 2011/016221

(57) **Abstract**

The present invention provides a heat sink having improved heat-exchange. A heat sink (10) which transfers heat dissipated from a heat generating device (12) to a cooling fluid (CF), said heat sink comprises: a planar base plate portion (11) that is thermally connected to the heat generating device (12); and a fin unit (10A) having a plurality of louvers (13) and a frame portion (14) that connects to the plurality of louvers and surrounds thereof. One edge of said plurality of louvers is thermally connected to the base plate portion; and said frame portion is situated apart from a principal surface of said base plate portion.

## Description

### Technical Field

The present invention relates to a heat sink for heat dissipating of the heat generating electronic components as represented by CPU, integrated circuits and semiconductor devices, and in addition to the electronic devices and electric devices in all fields. The present invention is particularly directed to a heat sink comprising a thin fin manufactured by processing a thin plate and has excellent heat dissipation.

### Description of the Related Art

The electronic devices, such as the CPU, integrated circuits and semiconductor devices, and electric devices are equipped with the heat sink. In order to satisfy the increase of the amount of the generated heat by the components or devices, demand for the heat sink that is excellent in heat dissipation is on a rise.

The heat sink disclosed in Japan Unexamined Patent Application No. 2009-026784 comprises a heat sink 200. As shown in FIG. 30 of Japan Unexamined Patent Application No. 2009-026784, a fin unit 20 comprises a plurality of rows of fins formed by making cuts in a predetermined shape. The predetermined shape in which the cuts are made consists of two sides of adjacent hook shapes and/or three sides of adjacent U-shapes, and the plurality of rows of fins are formed by raising cut portions. Between the rows of fins are the portions that were not cut and raised. The portions that were not raised are denoted as "connecting portions." Between the respective fins are the portions fins that were not raised, and the cross-section of the respective rows of fins that were cut and raised and not raised form L-shape fins. In the heat sink disclosed in Japan Unexamined Patent Application No. 2009-026784, one surface (bottom surface) of the L-shaped section of the fin and the connecting portions are connected to the base plate or heat generating device (hereinafter, the "base plate portion" refers to the "base plate and heat generating device").

However, in Japan Unexamined Patent Application no. 2009-026785, only one surface (perpendicular portion) of the L-shaped fin is raised from the base plate portion, and the remaining surface (bottom surface) is connected to the base plate portion in cohesive manner. Therefore, heat-exchange with the cooling fluid is affected only by the perpendicular surface, and thereby the heat sink disclosed in Japan Unexamined Patent Application no. 2009-026785 can be improved and provide more efficient heat-exchange.

The object of the invention is to provide a heat sink, which can effectively perform heat-exchange. More specifically, the present invention provides a heat sink comprising L-shaped fin surfaces, wherein both surfaces (vertical portions and bottom portions) are apart from the base plate.

### SUMMARY

A first aspect of the present invention is a heat sink. In its first aspect, the heat sink transfers heat dissipated from a heat generating device to a cooling fluid. The heat sink also comprises a planar base plate portion that is thermally connected to the heat generating device and a fin unit having a plurality of louvers and a frame portion that is connected to the plurality of louvers and surrounding thereof. Also, one edge of the plurality of louvers is thermally connected to the base plate portion, whereas the frame portion is situated away from the principal surface of the base plate portion. Whenever the frame portion is situated apart from the base plate portion and the cooling fluid is present inside the heat sink, turbulence occurs within the cooling fluid. Thus, the heat sink of the present aspect provides better cooling performance.

A second aspect of the present invention is a heat sink. In its second aspect of the heat sink, at least a part of the plurality of louvers is fabricated by cutting and forming from one metal plate, and the frame portion is fabricated by a portion of the metal plate that is not cut and formed.

A third aspect of the present invention is a heat sink. In its third aspect, the plurality of louvers has a distance extending parallel to a flow direction of the cooling fluid and a width for cutting and forming the louvers and angle for forming louvers; wherein at least several louvers from the plurality of louvers have different configuration in at least one aspect selected from a different length, a different width or different angle for cutting and bending.

A fourth aspect of the present invention is a heat sink. In its fourth aspect, the fin unit of the heat sink comprises a first fin unit fabricated by stamping one metal plate and a second fin unit fabricated by stamping another metal plate; wherein the louvers of the first fin unit differs from the louvers of the second fin unit in at least one aspect selected from a different length, a different width or a different angle for cutting and bending.

A fifth aspect of the present invention is a heat sink. In its fifth aspect, the fin unit of the heat sink comprises a first fin unit fabricated by stamping one metal plate, and a second fin unit fabricated stamping another metal plate; wherein one edge portion of the louvers of the first fin unit is thermally connected to the base plate portion, and one edge portion of the louvers of the second fin unit is thermally connected to the other edge portion of the louvers of the first fin unit.

A sixth aspect of the present invention is a heat sink. In its sixth aspect, a frame portion of the first fin unit and a frame portion of the second fin unit are situated apart from each other.

A seventh aspect of the present invention is a heat sink. In its seventh aspect, the frame portion of the first fin unit and the frame portion of the second fin unit are connected with each other.

An eighth aspect of the present invention is a heat sink. In its eighth aspect, the fin unit of the heat sink comprises the first fin unit fabricated by stamping one metal plate, and the second fin unit fabricated stamping another metal plate; wherein the plurality of louvers of the first fin unit is situated between the plurality of louvers of the second fin unit.

A ninth aspect of the present invention is a heat sink. In its ninth aspect, the frame portion of the heat sink comprises a flow-channel changing portion for changing a flow direction of the cooling fluid.

A tenth aspect of the present invention is a heat sink. In its tenth aspect, the cooling fluid inside the heat sink is liquid, and a cover plate connected to the other edge of the plurality of louvers is situated so as to constitute flow direction of the cooling fluid CF of the liquid.

An eleventh aspect of the present invention is a heat sink. In its eleventh aspect, a fin unit is fabricated by stamping one metal plate, and the fin unit is mounted onto the base plate portion by using filler.

A twelfth aspect of the present invention is a heat sink. In its twelfth aspect, a base material of the metal plate of the heat sink is aluminum, and filler is cladded onto at least one principal surface.

A thirteenth aspect of the present invention is a heat sink. In its thirteenth aspect, the heat sink transfers heat generated by a heat generating device to the cooling fluid. The heat sink also comprises a planar base plate portion that is thermally connected to the heat generating device and a fin unit having a plurality of louvers and a frame portion that is connected to the plurality of louvers and surrounding thereof. Whenever one edge portion of the plurality of louvers is thermally connected to the base plate portion, a wall of the flow channel is situated at a position facing the base plate portion, the fin unit is situated between the base plate and the wall of the flow channel constitutes the flow channel of the cooling fluid, and the frame portion is connected to the wall of flow channel in coherent manner.

A fourteenth aspect of the present invention is a heat sink. In its fourteenth aspect, a cooling fluid of the heat sink is liquid, and a cover plate is situated so as to constitute a flow-channel of the liquid cooling fluid. The cover plate is connected to the other edge of the plurality of louvers and forms the flow-channel wall.

The heat sink of the present invention has effective heat dissipation and can be manufactured easily.

### Brief Description of the Drawings

FIG. 1 is a perspective view of a first heat sink 100A in the first embodiment.
FIG. 2 is a side view of the first heat sink 100A in the first embodiment as viewed from the -X-axis direction.
FIG. 3 is a plan view of the first heat sink 100A in the first embodiment.
FIG. 4A is a side view of the second heat sink 100B of the second embodiment as viewed from the -Y-axis direction.
FIG. 4B is a side view of the third heat sink 100B of the third embodiment as viewed from the -Y-axis direction.
FIG. 4C is a side view of the fourth heat sink 100D of the fourth embodiment as viewed from the -Y-axis direction.
FIG. 5 is a schematic view of a fifth heat sink 100E in the fifth embodiment.
FIG. 6 is a schematic view of a sixth heat sink 100F in the sixth embodiment.
FIG. 7 is a schematic view of a sixth heat sink 100F in the sixth embodiment.
FIG. 8 is a schematic view of a seventh heat sink 100G in the sixth embodiment.
FIG. 9 is a side view of the seventh heat sink 100G in the seventh embodiment viewed from the -X-axis direction.
FIG. 10 is a schematic view of the eighth heat sink 100H in the eighth embodiment.
FIG. 11 is a side view of the eighth heat sink 100H in the eighth embodiment viewed from the -X-axis direction.
FIG. 12 is an exploded perspective view of the ninth heat sink 100J in the ninth embodiment.
FIG. 13 is a schematic view of the ninth heat sink 100J in the ninth embodiment.
FIG. 14 is an exploded perspective view of a tenth heat sink 100K in the tenth embodiment.
FIG. 15 is an exploded perspective view of a tenth heat sink 100K in the tenth embodiment.
FIG. 16 is an exploded perspective view of an eleventh heat sink 100L in the eleventh embodiment.
FIG. 17A is a side view of the eleventh heat sink 100L in the eleventh embodiment.

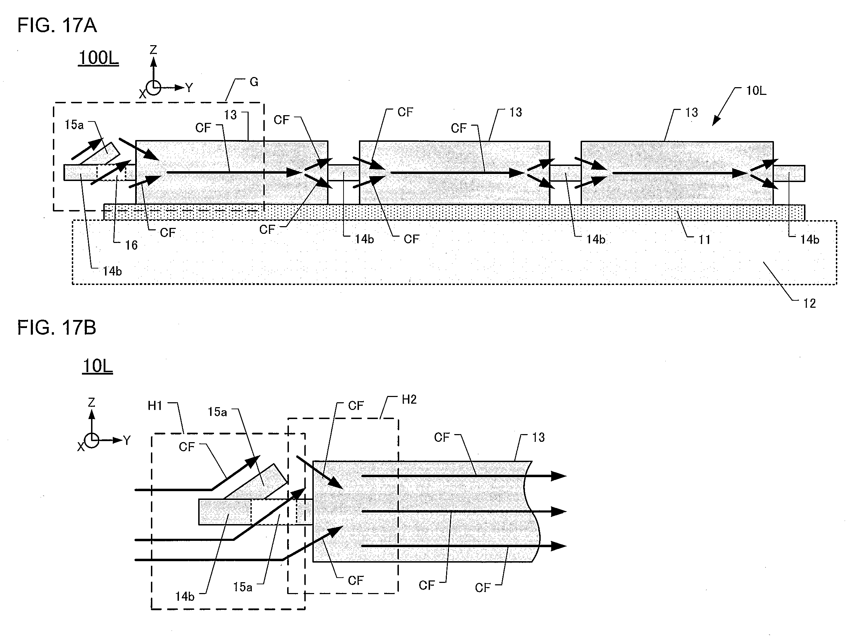

FIG. 17A includes an upstream flow-channel changing portion 15a.
FIG. 17B is an exploded view of the dashed line G in FIG. 17A.

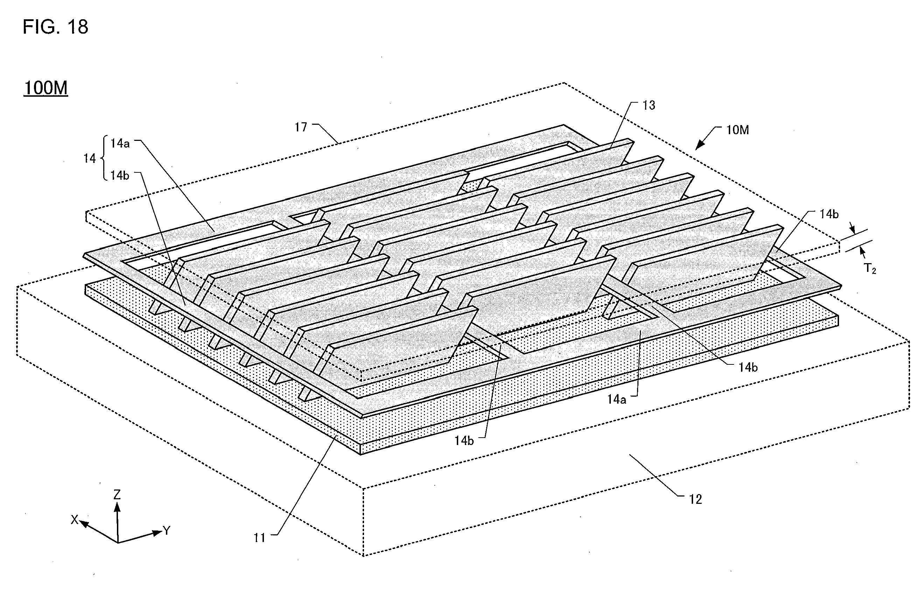

FIG. 18 is a schematic view of a twelfth heat sink 100M in the twelfth embodiment.

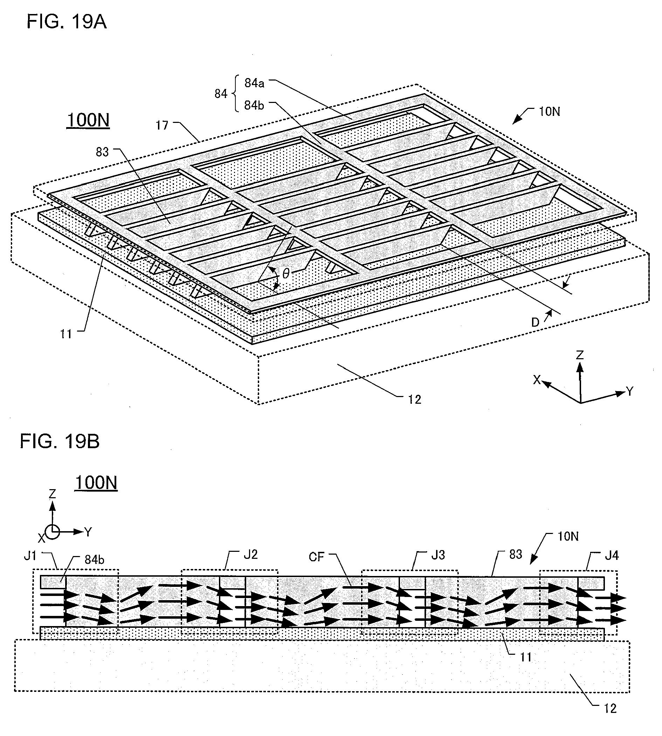

FIG. 19A is a schematic view of the thirteenth heat sink 100N in the thirteenth embodiment.
FIG. 19B is a side view of the thirteenth heat sink 100N in the thirteenth embodiment viewed from the -X-axis direction.

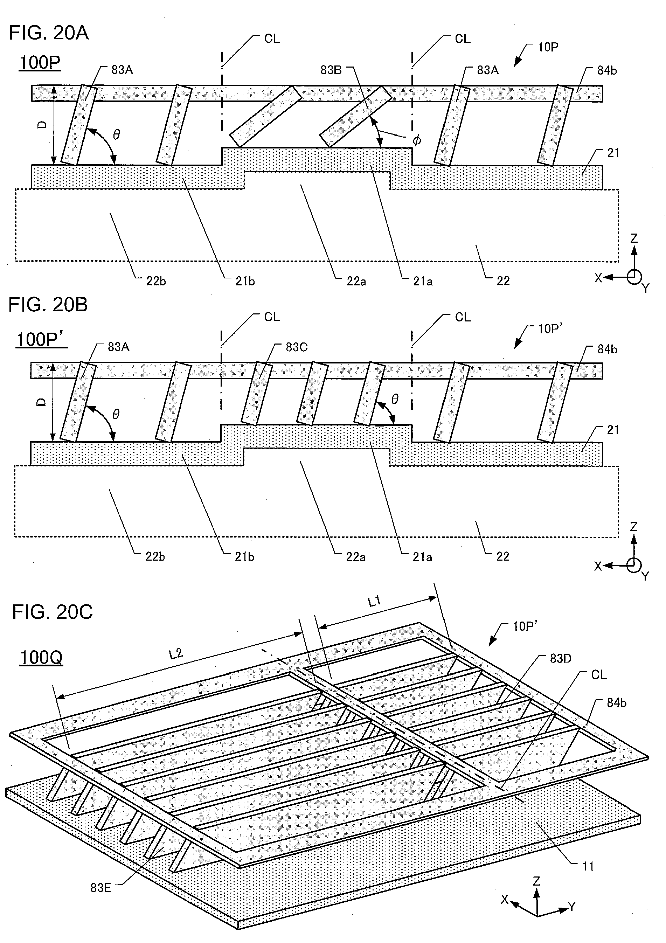

FIG. 20A is a side view of a fourteenth heat sink 100P in the fourteenth embodiment viewed from the -Y-axis direction.
FIG. 20B is a side view of the fourteenth heat sink 100P' which is an alternative to the fourteenth embodiment, as viewed from the -Y-axis direction.
FIG. 20C is a schematic view of a fifteenth heat sink 100Q in the fifteenth embodiment.

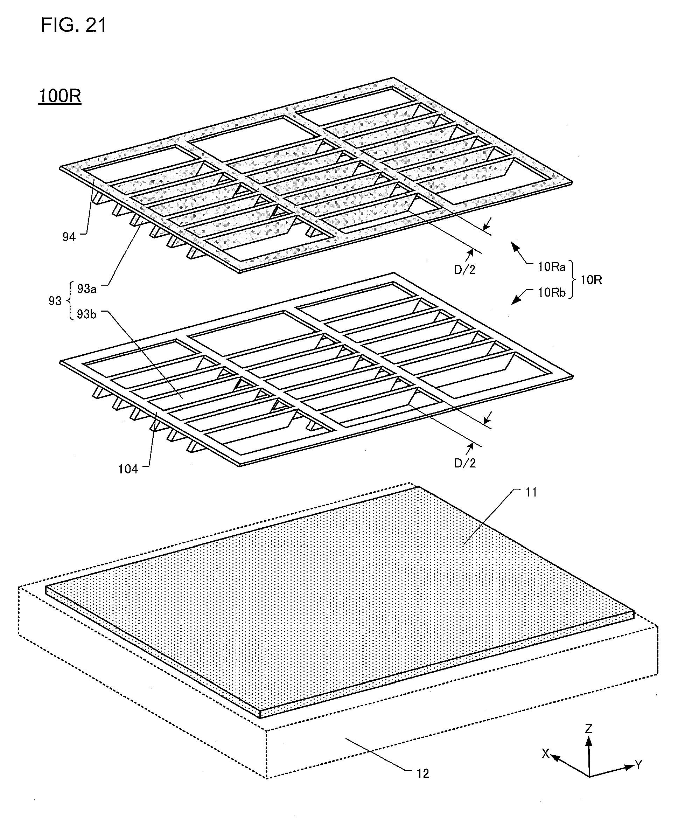

FIG. 21 is an exploded perspective view of a sixteenth heat sink 100R in the sixteenth embodiment.

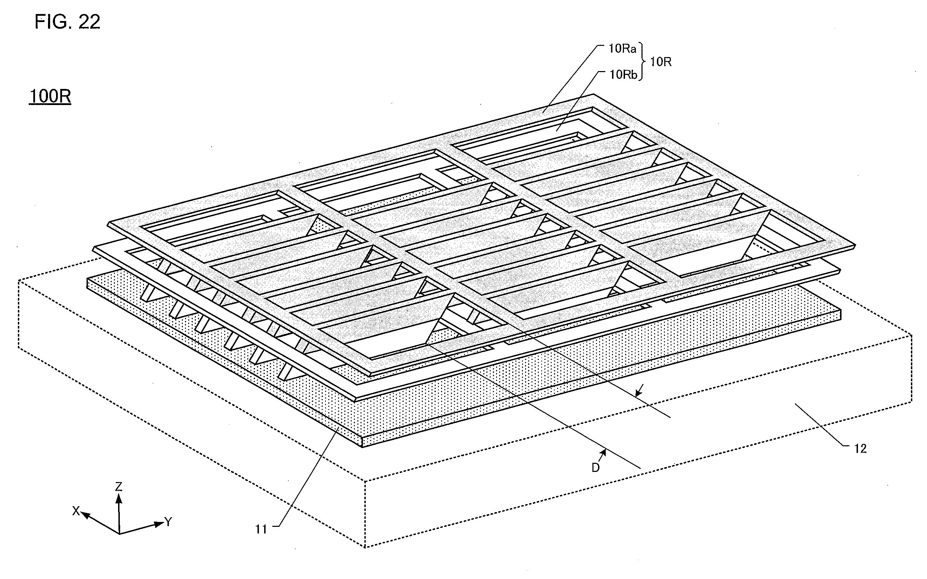

FIG. 22 is a schematic view of a sixteenth heat sink 100R in the sixteenth embodiment.

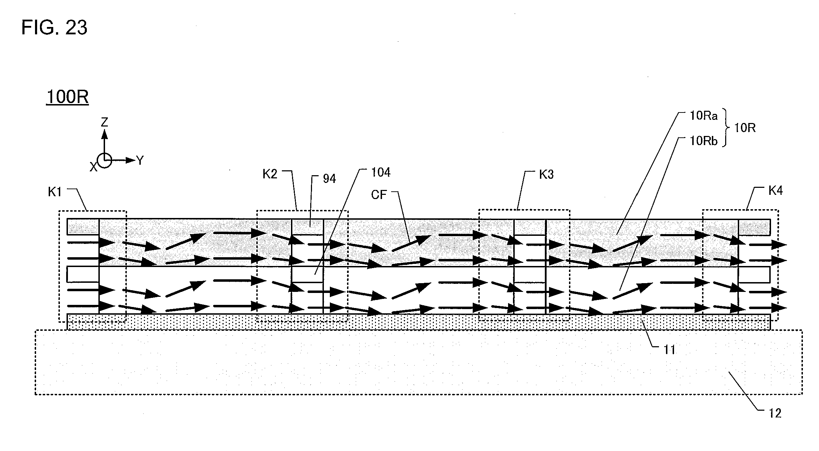

FIG. 23 is a side view of the sixteenth heat sink 100R in the sixteenth embodiment viewed from the -X-axis direction.

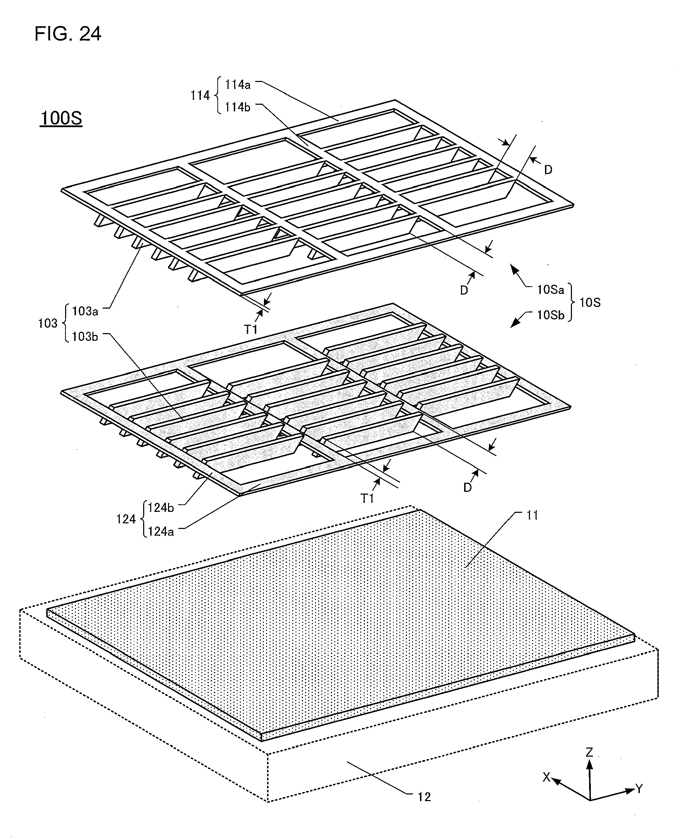

FIG. 24 is an exploded perspective view of a seventeenth heat sink 100S in the seventeenth embodiment.

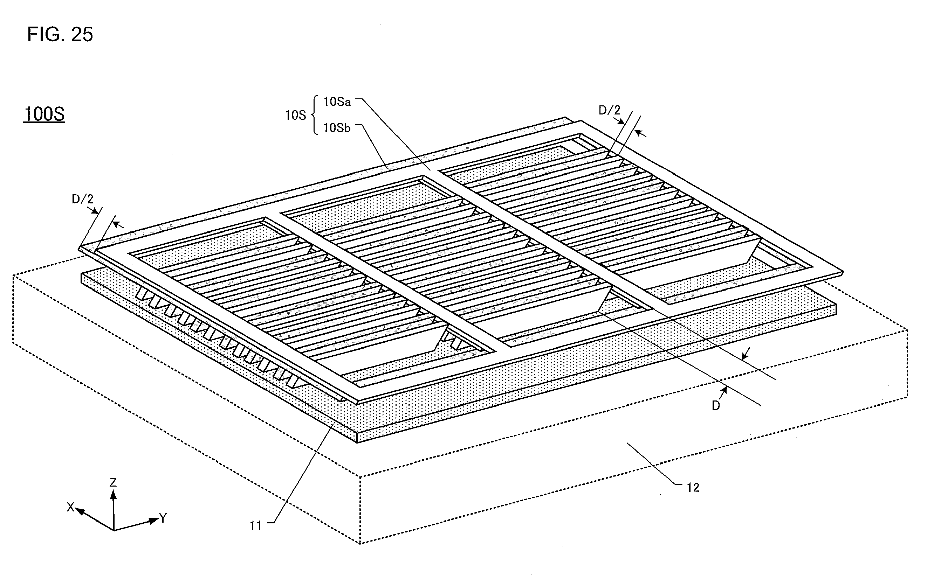

FIG. 25 is a schematic view of the seventeenth heat sink 100S in the seventeenth embodiment.

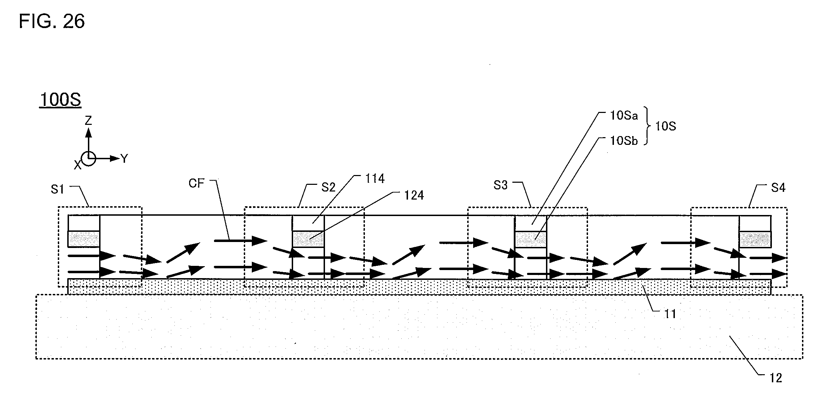

FIG. 26 is a side view of the seventeenth heat sink 100S in the seventeenth embodiment as viewed from the -X-axis direction.

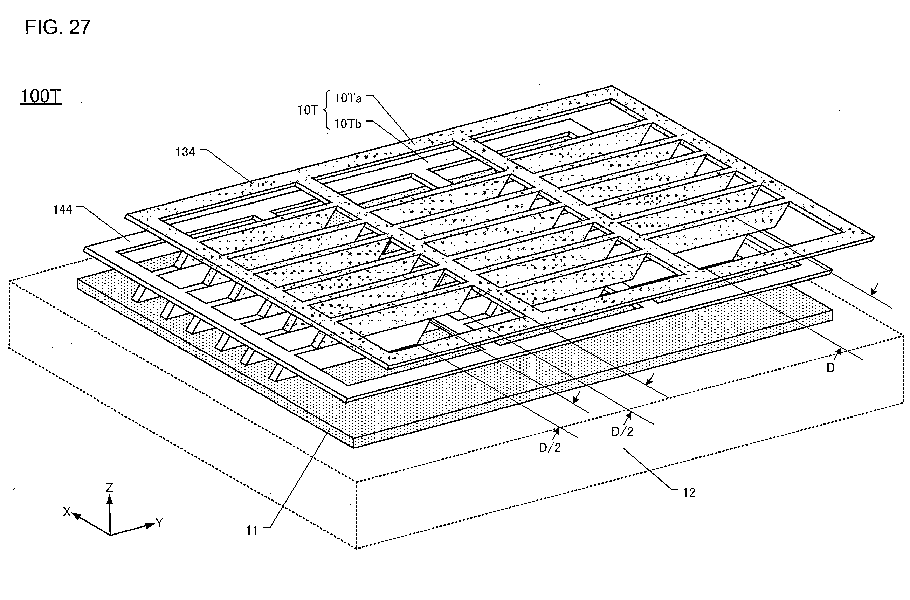

FIG. 27 is a schematic view of an eighteenth heat sink 100T in the eighteenth embodiment.

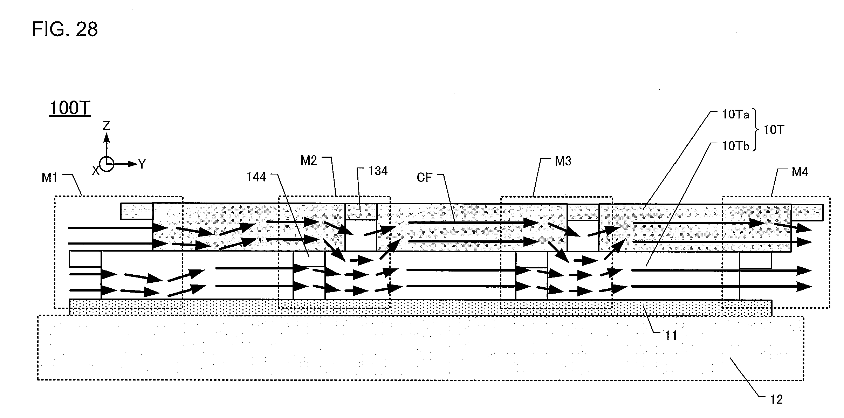

FIG. 28 is a side view of an eighteenth heat sink 100T in the eighteenth embodiment viewed from the -X-axis direction.

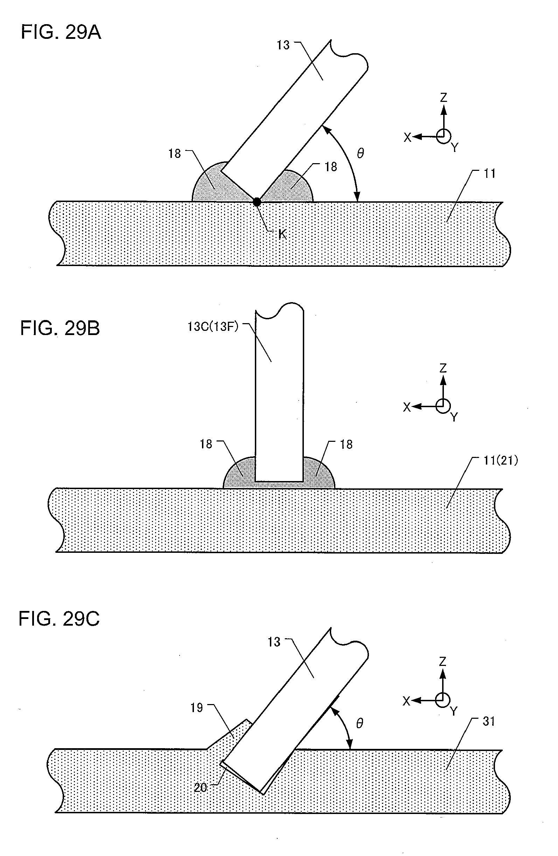

FIG. 29 is a drawing of a louver contacting the base plate portion.
FIG. 29A is a drawing explaining the louvers 13 bonded to the base plate portion 11 diagonally by using filler in the previous first to eighteenth embodiments.
FIG. 29B is a drawing explaining the louvers 13C and 13F bonded to the base plate portions 11 and 21 perpendicularly by using filler in the previous third and fourth embodiments.
FIG. 29C is a drawing explaining the louver 13 bonded to the base plate portion 11 by swaged portion 19 in the previous first to eighteenth embodiments.

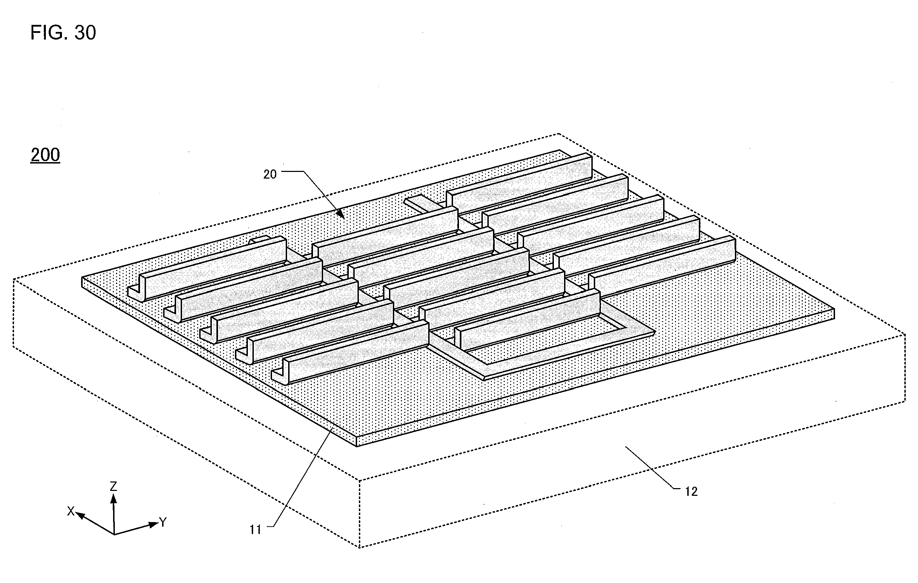

FIG. 30 is a schematic view of a conventional heat sink 200.

### Detailed Description

### FIRST EMBODIMENT

### <Configuration of the First Heat Sink 100A>

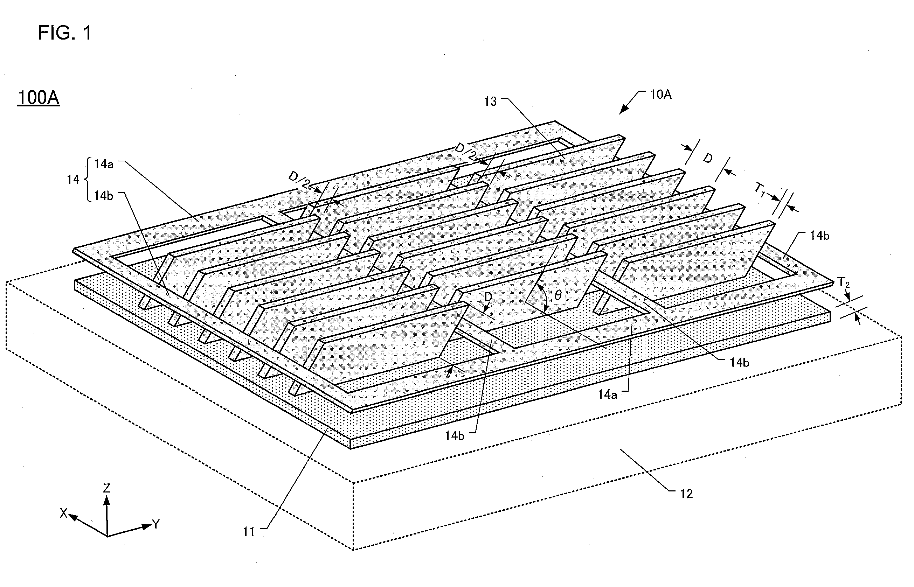

FIG. 1 is a perspective view of a first heat sink 100A in the first embodiment. Here, a surface of a base plate portion 11 is denoted as the XY-plane, and a direction perpendicular to the base plate portion is denoted as the +Z-axis direction.

As shown in FIG. 1, the first heat sink 100A is mounted onto a heat generating device 12, such as a semiconductor device, integrated circuit or CPU. To provide a better understanding, the heat generating device 12 is drawn; however it does not constitute a part of the first heat sink 100A. The first heat sink 100A comprises a planar base plate portion 11 mounted onto the XY-plane of the heat generating device 12 in coherent manner and a first fin unit 10A that is thermally connected to the base plate portion 11. In the first embodiment, the first fin unit 10A is constituted of one metal plate, and the metal plate forms a plurality of louvers 13 that are cut and formed diagonally along the ±Z-axis direction relative to the metal plate and a frame portion 14, connected to the plurality of louvers 13, which are not cut and remains. One edge of the louvers 13 on the first fin unit 10A is thermally connected to the base plate portion 11 by using filler for example. Also, the frame portion 14 comprises a frame portion 14a in the Y-axis direction and a frame portion 14b in the X-axis direction, and to avoid from the frame portion 14 being connected to a principal surface of the base plate portion 11, the frame portion 14 is connected essentially at the center portion of the louver 13 in the Z-axis direction. Also, although the first heat sink 100A in FIG. 1 comprises a single fin unit 10A having eighteen louvers 13 (six louvers in the X-axis direction and three louvers in the Y-axis direction), there can be as many as several dozens to several hundreds of the first fin unit 10A.

In the first embodiment, the first fin unit 10A is fabricated by stamping one plate of metal material having excellent heat transfer, such as aluminum, copper or alloy thereof, and thickness of the metal plate T₁ is between 0.4mm to 2mm. Also, width D of the louver 13 is approximately between 2mm to 20mm, and the distance between two adjacent louvers 13 in the X-axis direction almost equals to the width D. Furthermore, the thickness T₂ of the base plate portion 11 is approximately 0.5mm to 15mm and the base plate portion 11 is fabricated by stamping one plate of metal material having excellent heat transfer, such as aluminum, copper or alloy thereof. The base plate portion 11 is a plate having a rectangular profile, which is similar to the heat generating device 12.

Furthermore, the angle θ for cutting and forming the louver 13 from the frame portion 14 can be set at an arbitrary angle between 10 degrees to 90 degrees. Although in FIG. 1, the louver 13 is cut from the frame portion 14 at D/2 distance from the louver 13, it can be cut and angled at an arbitrary position.

Furthermore, between each row of louvers 13 aligned along the Y-axis direction, a frame portion 14b is situated along the X-axis direction. The frame portion 14b in the X-axis direction is situated apart from the base plate portion 11 in the Z-axis direction. Thus, the frame portion 14b in the X-axis direction is not directly connected to the base plate portion 11. Furthermore, as shown in FIG. 1, a row of adjacent louver 13 is off-set by a D/2 distance in the X-axis direction with respect to the louvers in an adjacent row. For example, whenever a row of louvers 13 is off-set by a distance D/2 in the X-axis direction, a louver 13 on the first row is situated between two louvers 13 on the second row. This formation improves heat transfer of the first heat sink 100A, as will be explained hereafter. Also, the adjacent row of louvers 13 does not need to be off-set in the X-axis direction, and its position can be adjusted as necessary.

### <Cooling of the First Heat Sink 100A>

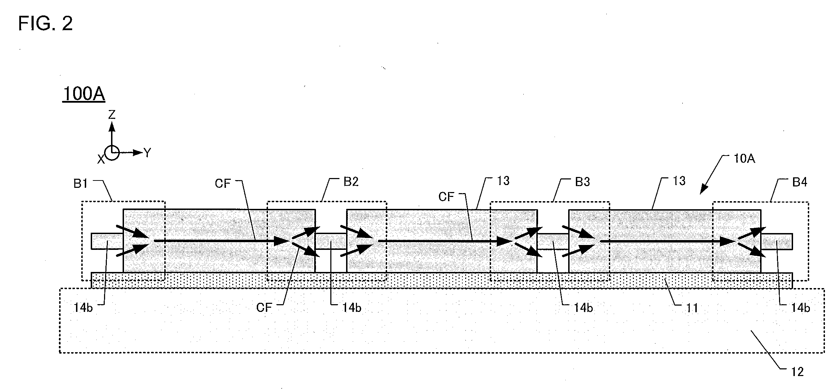

FIG. 2 is a side view of the first heat sink 100A in the first embodiment as viewed from the -X-axis direction. In FIG. 2, bold arrows represent a flow direction of the cooling fluid CF. The cooling fluid CF flows along the +Y-axis direction. The embodiments below are explained with assumption that vapors such as air are used as the cooling fluid CF; however it can be replaced with water or antifreeze solution.

As shown in the dotted line B1 in FIG. 2, since the frame portion 14b in the X-axis direction is apart from the base plate portion 11 in the Z-axis direction, cooling fluid CF inside the first heat sink 100A collides with the frame portion 14b in the X-axis direction, which causes turbulence. This allows the cooling fluid CF to absorb heat from the surface of the louver 13 on the downstream, as well as to absorb heat from the base plate portion 11. This provides improved heat transfer of the first heat sink 100A.

Then turbulent cooling fluid CF becomes laminar airflow. However, at the dotted line B2, the cooling fluid CF becomes turbulent due to the presence of the frame portion 14b in the X-axis direction. Specifically, laminar airflow between two louvers 13 collides with the frame portion 14b in the X-axis direction situated at the center of the louver 13 in the Z-axis direction. This separates airflow of the frame portion 14b toward both sides of the Z-axis direction, and flows into both Z-axis directions of the frame portion 14b in the X-axis direction as turbulence.

Also, whenever the cooling fluid CF collides with the frame portion 14b in the X-axis direction, the cooling fluid CF becomes turbulent at the dotted line B3, as similar to the dotted line B2. Finally, the cooling fluid CF is separated to both sides of the Z-axis direction at the dotted line B4, and becomes turbulent at the frame portion 14b in the X-axis direction. Then, the cooling fluid CF is released from the +Y-axis side of the first heat sink 100A.

As mentioned above, the cooling fluid CF entered into the first heat sink 100A from the -Y-axis direction causes turbulence inside the first heat sink 100A, which facilitates heat-exchange with the louver 13 or the base plate portion 11. This turbulence causing configuration improves heat transfer and heat dissipation between the heat generating device 12 and the cooling fluid CF.

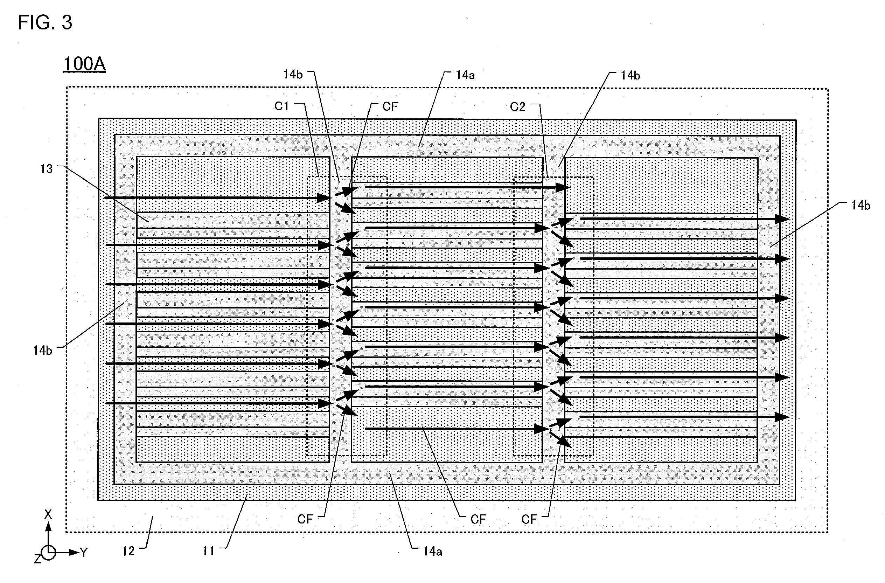

FIG. 3 is a plan view of the first heat sink 100A in the first embodiment. In FIG. 3, the arrows represent the flow direction of the cooling fluid CF. The cooling fluid CF flows along the +Y-axis direction.

In FIG. 3, the cooling fluid CF enters between adjacent louvers 13 of the first heat sink 100A from the -Y-axis direction. The adjacent louvers 13 are situated at the distance D/2 apart from each other in the X-axis direction, and whenever cooling fluid CF enters from the louver 13 in the -Y-axis direction, the cooling fluid CF collides with the louver 13 situated at the center. Thus, the cooling fluid CF is separated into both X-axis directions, and becomes turbulent. Then the cooling fluid CF flows along the louver 13 in the center row along the +Y-axis direction.

Similar to the dotted line C1, the cooling fluid CF becomes turbulent at the dotted line C2, due to the presence of the louver 13 row situated in the +Y-axis direction. Then, the first heat sink 100A is released from the +Y-axis direction.

As explained above, the cooling fluid CF entered from the -Y-axis direction of the first heat sink 100A becomes turbulent inside the first heat sink 100A and facilitates heat-exchange. Turbulence in the cooling fluid CF increases heat transfer between the heat generating device 12 and the cooling fluid CF, and this increases thermal dissipation from the heat generating device through the heat sink 100A.

Also, the first fin unit 10A is manufactured as one unit by stamping, which reduces manufacturing cost. Also, the louvers 13 of the first fin unit 10A are connected by the frame portion 14 that was not cut and formed, which makes the fin unit easy to handle. In the first embodiment, although the distance D and width D between each louver 13 in the X-axis direction are constant, the distance and width can be altered by changing the shape of the mold for stamping and changing the position of the metal plate that has not been cut and angled. Therefore, major cost increase is not necessary.

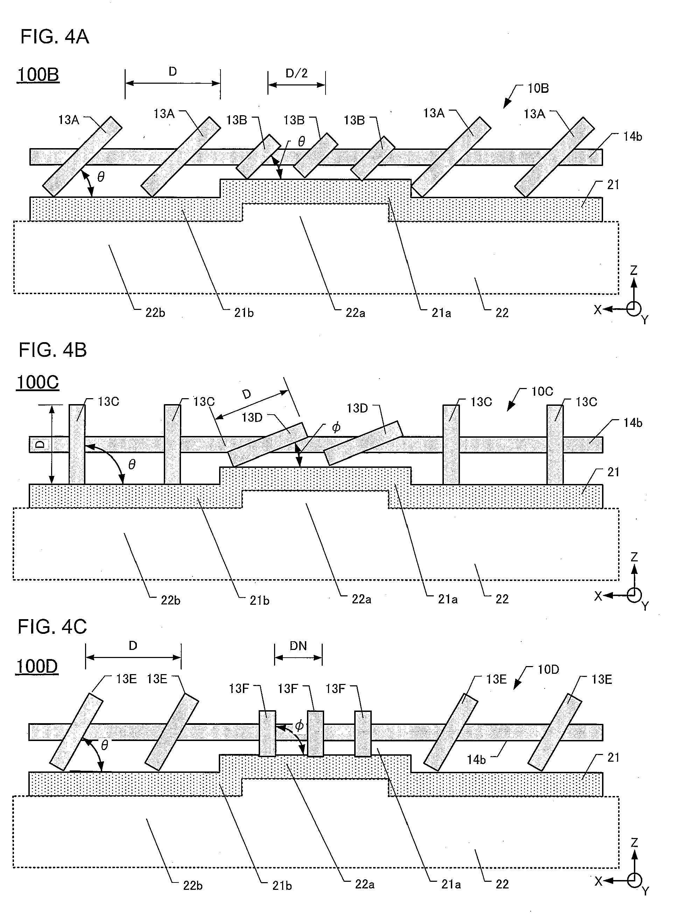

FIG. 4 depicts heat sinks in the second to fourth embodiments. The distance D and width between each louver in the X-axis direction are altered.

### SECOND EMBODIMENT

### <Configuration of the Second Heat Sink 100B>

FIG. 4A is a side view of the second heat sink 100b of the second embodiment as viewed from the -Y-axis direction. To provide a better understanding, the heat generating device 22 is drawn; however it does not constitute a part of the first heat sink 100B. In the second embodiment, the heat generating device 22 comprises a stepwise portion 22a (this can be either protruding surface or recessed surface) in the center of a planar portion 22b. The heat generating device 22 having such stepwise portion comprises a stepwise portion 21a and a planar portion 21b in the center of the base plate portion 21. The stepwise portion is configured so as to efficiently release heat by creating larger contacting area between the base plate portion 21 and the heat generating device 22. The louvers are preferred to be adjusted to the stepwise portion 21 a and the planar portion 21 b of the base plate portion 21.

As shown in FIG. 4A, the second fin unit 10B in the second embodiment comprises two types of louvers: the louvers 13A and the louvers 13B. The louvers 13A have the same configuration as the louvers 13 of the first fin unit 10A in the first embodiment. The louvers 13A are angled at θ degrees, and connected to the planar portion 21b of the base plate portion 21 by using filler, for example. The louver 13B is angled at same angle as the louvers 13A at θ degrees, and connected to the planar portion 21a of the base plate portion 21 by using filler, for example. The width of the louvers 13B is shorter than the width of the louvers 13A. For example, if the height of the stepwise portion 21a of the base plate portion 21 is D/4, the width of the louver 13B is D/2. Thus, all louvers 13A and 13B are thermally connected to the base plate portion 21 at angle θ.

Also, the second fin unit 10B in the second embodiment does not require a major cost increase, since such changes can be accomplished by changing the shape of the mold for stamping, and changing the position of the louver and the width so that it matched to the stepwise portion 21 a and the planar portion 21 b of the base plate portion 21.

### SECOND EMBODIMENT

### <Configuration of the Third Heat Sink 100C>

FIG. 4B is a side view of the third heat sink 100C of the third embodiment as viewed from the -Y-axis direction. In the third embodiment, the heat generating device 22 comprises a stepwise portion 22a in the center and a planar portion 22b. Such a heat generating device 22 having a stepwise portion comprises a stepwise portion 21 a and a planar portion 21 b at the center of the base plate portion 21.

As shown in FIG. 4B, the third fin unit 10C in the third embodiment comprises two types of louvers: the louvers 13C and the louvers 13D. In the third embodiment, the louvers 13C have the same width D as the louver 13 of the first fin unit 10A in the first embodiment. The louvers 13C are situated perpendicularly to the planar portion 21 b, and connected to the planar portion 21 b of the base plate portion 21 by using filler, for example. Also, the louvers 13D have same distance D as the louver 13 of the fin unit 10A in the first embodiment. However, the angle ϕ of the louvers 13D is smaller than then angle θ, and is bonded to the stepwise portion 21 a of the base plate portion 21 by filler, for example. Thus, all louvers 13C and 13D are thermally connected to the base plate portion 21. There can be numerous height differences between the stepwise portion 21 a and the planar portion 21 b of the base plate portion 21, and the louvers 13C and 13D can be adjusted to an appropriate angle.

Also, the third fin unit 10C in the third embodiment does not require a major cost increase, since such changes can be accomplished by changing the shape of the mold for stamping, and changing the position of the louver and the width so that it matched to the stepwise portion 21 a and the planar portion 21 b of the base plate portion 21.

### FOURTH EMBODIMENT

### <Configuration of the Third Heat Sink 100D>

FIG. 4C is a side view of the fourth heat sink 100D of the fourth embodiment as viewed from the -Y-axis direction. In the fourth embodiment, the heat generating device 22 comprises a stepwise portion 22a and a planar portion 22b to each side of the stepwise portion 22a. Such heat generating device 22 having a stepwise portion comprises a stepwise portion 21 a and a planar portion 21 b at the center of the base plate portion 21.

As shown in FIG. 4C, the fourth fin unit 10D in the fourth embodiment comprises two types of louvers: the louvers 13E and the louvers 13F. In the fourth embodiment, the louvers 13E are mounted onto the recessed portions of the base plate portion 21 at angle θ, which is similar as the louver 13A of the second fin unit 10B in the second embodiment. Also, the angle ϕ for situating the louvers 13F is a right angle, and is mounted onto the stepwise portion 21a of the base plate portion 21 by using filler, for example. The width DN of the louver 13F is much narrower than the width D of the louver 13E. Therefore, all louvers 13E and 13F are thermally connected to the base plate portion 21 having protruding surface.

The previous second to fourth embodiments were examples of changing the distance between the louvers and altering angles of the louvers based on the stepwise portion 21 a and the planar portion 21 b of the base plate portion 21. The distance between louvers 13 and the angles thereof can be altered if more than three stepwise portions are present, or depending on the increase of the amount of heat generated by the heat generating device 22.

### FIFTH EMBODIMENT

### <Configuration of the Third Heat Sink 100E>

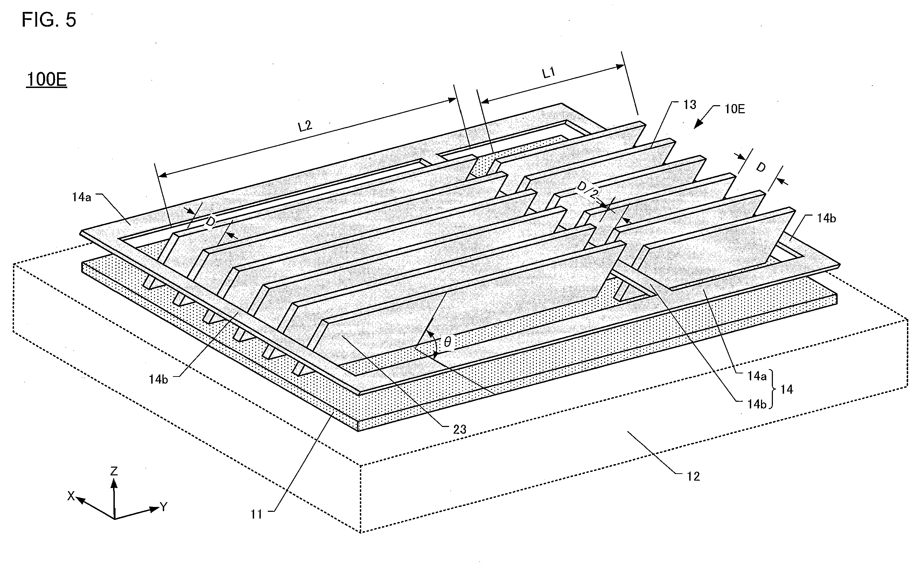

FIG. 5 is a schematic perspective view of the fifth heat sink in the fifth embodiment. In the fifth embodiment, since only the fifth fin unit 10E differs from the first embodiment, the fifth fin unit 10E is explained in this embodiment. Explanations regarding other components are omitted.

As shown in FIG. 5, the fifth fin unit 10E comprises multiple louvers 13, multiple louvers 23 and a frame portion 14 that are fabricated by stamping one metal plate. The fifth fin unit 10E is thermally connected to the base plate portion 11 E by bonding one edge of the louvers 13 and louvers 23 to the base plate portion 11 using filler. Also, the frame portion 14 is situated apart from the principal surface of the base plate portion 11. The frame portion 14 comprises the frame portions 14a in the Y-axis direction and the frame portions 14b in the X-axis direction, and the frame portions 14b in the X-axis direction are connected to essentially center of the louvers 13 and 23 in the Z-axis direction.

In FIG. 5, the fifth heat sink 100E includes a row of louvers 13 constituted of six short louvers 13 and a row of louvers 23 constituted of six long louvers 23, both extending in the X-axis direction. Although there is only one fin unit in FIG. 5, there can be several dozens to several hundreds of the fifth fin unit 10E on the base plate portion 11.

In the fifth embodiment, materials and thickness of the fifth fin unit 10E are the same as the previous first embodiment, and the angle θ between the frame portion 14 and louvers 13 and 23 is the same as the first embodiment. Also, each row of louvers 13 or 23 in the X-axis direction is offset by D/2 distance from adjacent louvers in the X-axis direction.

In the fifth fin unit 10E, the length L2 of the louver 23 in the Y-axis direction is as twice as long as the length L1 of the louver 13. By adjusting the Y-axis position of the frame portions 14b in the X-axis direction where turbulence of the cooling fluid CF occurs, a partial cooling efficiency and fluid resistance of the cooling fluid CF can be adjusted. Thus, by providing two types of louvers 13 and 23 having different length, cooling efficiency can be adjusted at a particular position of the base plate portion 11.

Also, although the fifth fin unit 10E in the fifth embodiment comprises a row of louvers 13 and a row of louvers 23 fabricated by one metal plate, a fin unit for a row of louvers 13 and a fin unit for a row of louvers 23 can be fabricated by a separate metal plate and can be put together into one base plate portion 11.

### SIXTH EMBODIMENT

### <Configuration of the Third Heat Sink 100F>

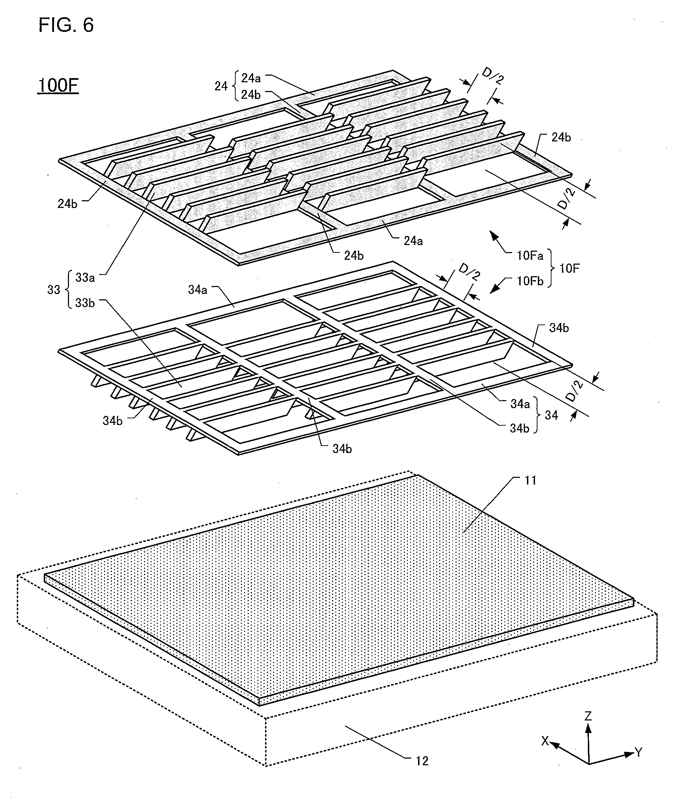

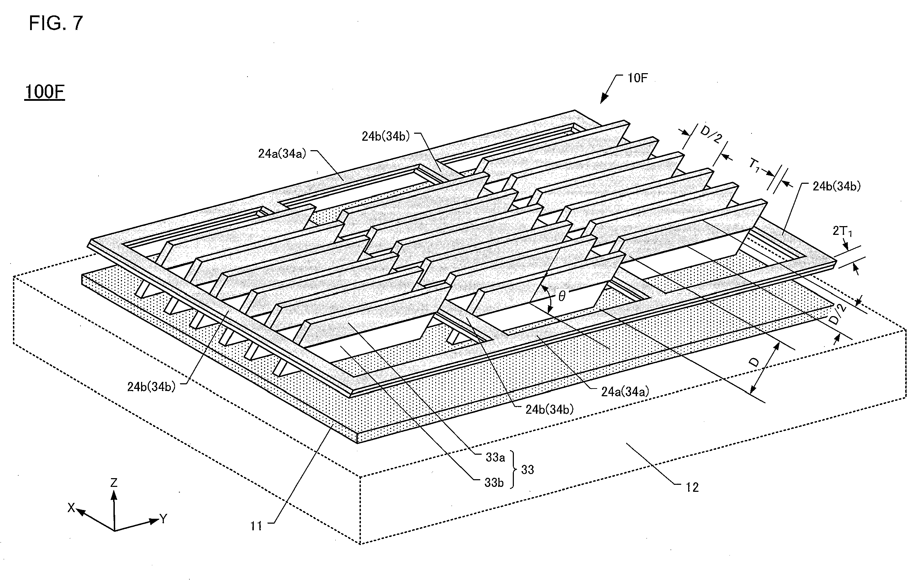

FIG. 6 is a schematic view of a sixth heat sink 100F in the sixth embodiment. FIG. 7 is a schematic view of a sixth fin unit 10F after being assembled. In the sixth embodiment, the sixth fin unit 10F is a duplex fin unit constituted of a first fin unit 10Fa and a second fin unit 10Fb.

First, a first fin unit 10Fa in the sixth fin unit 10F is explained below.

The first fin unit 10Fa is fabricated by one metal plate, and the metal plate forms a plurality of louvers 33a that are cut and bent diagonally relative to the metal plate and a frame portion 24 that are connected to the plurality of louvers 33a and not cut and remains. Also, the frame portion 24 comprises the frame portions 24a in the Y-axis direction and the frame portions 24b in the X-axis direction. Also, the frame portions 24b in the X-axis direction are connected to one edge of the louvers 33a in the Z-axis direction. In FIG. 6, the first fin unit 10Fa includes eighteen louvers 33a, and each row has six louvers in the X-axis direction and the first fin unit 10Fa has three rows of louvers in the Y-axis direction. Also, the material and thickness of the first fin unit 10Fa are the same as the first fin unit 10A in the first embodiment, and angle θ between the frame portion 24 and the louver 33a is as the same as in the first embodiment. In the sixth embodiment, the width between adjacent louvers 33a is D/2.

Next, the second fin unit 10Fb in the six fin unit 10F is explained. The second fin unit 10Fb is fabricated from one metal plate, and the metal plate forms a plurality of louvers 33b that are cut and bent diagonally in the Z-axis direction relative to the metal plate, and a frame portion 34 that are connected to the plurality of louvers 33b and not cut and remains. Also, the frame portion 34 comprises the frame portions 34a in the Y-axis direction and the frame portions 34b in the X-axis direction. Also, the frame portions 34b in the X-axis direction are connected to one edge of the louvers 33b in the Z-axis directions. Other configurations in the second fin unit 10Fb, including the angle θ, are the same as the first fin unit 10Fa.

As shown in FIG. 7, the first fin unit 10Fa and the second fin unit 10Fb are bonded together by bonding corresponding edges of the louvers 33a and 33b, thus the frame portion 24b in the X-axis direction and the frame portion 34b in the Y-axis direction, are bonded together, thereby forming the sixth fin unit 10F. The thickness of the frame portion 24 and 34 bonded together is twice as thick as the frame portion 14 in the first embodiment, or is 2T₁. The width of the new louver 33 formed by combining the louvers 33a and 33b is denoted as D, the distance in the X-axis direction is D/2, and its thickness is T₁.

Also, the overall configuration of the sixth fin unit 10F after assembly is similar to the configuration of the first fin unit 10A in the first embodiment; however, the distance between the adjacent louvers 33 in the X-axis direction is D/2.

In the sixth embodiment, by mounting the sixth fin unit 10F constituted of a plurality of fin portions onto the base plate portion 11, the distance between the louver 33 in the X-axis direction can be shortened from distance D to distance D/2, which increases the density of the louvers and provides improved heat transfer.

### SEVENTH EMBODIMENT

### <Configuration of the Third Heat Sink 100G>

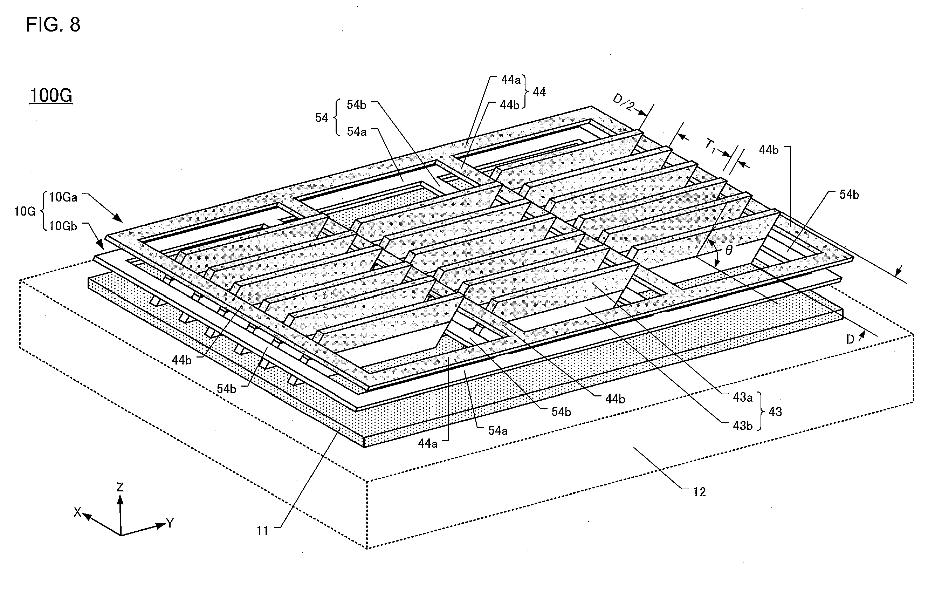

FIG. 8 is a schematic view of the seventh heat sink 100G in the seventh embodiment. In the seventh embodiment, the seventh fin unit 10G is a duplex fin unit constituted of a first fin portion 10Ga and a second fin portion 10Gb.

First, the first fin portion 10Ga of the seventh fin unit 10G is explained. The first fin portion 10Ga comprises one metal plate, and the metal plate forms a plurality of louvers 43a that are cut diagonally along the ±Z-axis direction relative to the metal plate and a frame portion 44 connected to the plurality of louvers 43a that are not cut and remains. Also, the frame portion 44 is comprised of the frame portions 44a in the Y-axis direction and the frame portions 44b in the X-axis direction. Also, the frame portions 44b in the X-axis direction is connected to the center portion of the louvers 43a in the Z-axis direction. In FIG. 8, the first fin portion 10Ga comprises eighteen louvers 43a, with six louvers in each row in the X-axis direction and three rows of louvers in the Y-axis direction. Also, the material and thickness of the first fin portion 10Ga is the same as the first fin unit 10A in the first embodiment, and the angle θ in the between the frame portion 44 and the louver 43a is the same as in the first embodiment. However, the width of the louver 43a in the seventh embodiment is D/2 of the width of the first louver 13 in the first embodiment.

Also, in the seventh embodiment, the second fin portion 10Gb has the same configuration as the first fin portion 10Ga.

As shown in FIG. 8, the first fin portion 10Ga and the second fin portion 10Gb are thermally bonded at the edge portion of the louver 43a and the edge portion of the louver 43b by using filler. Thus, the seventh fin unit 10G is manufactured. Also, the frame portion 44b in the X-axis direction is connected to the center of the louver 43a in the Z-axis direction, and the frame portions 54b in the X-axis direction is connected to the center of the plurality of louvers 43b in the Z-axis direction. Therefore, the frame portion 44 and the frame portion 54 are separated in the Z-axis direction. The distance between the frame portions is determined by the cutting direction of the louvers 43a and 43b. Furthermore, the new louvers 43 constituted of the louver 43a and 43b has width D, the distance between louvers in the X-axis direction is D/2 and has the thickness T₁.

### <Cooling Using the Seventh Heat Sink 100G>

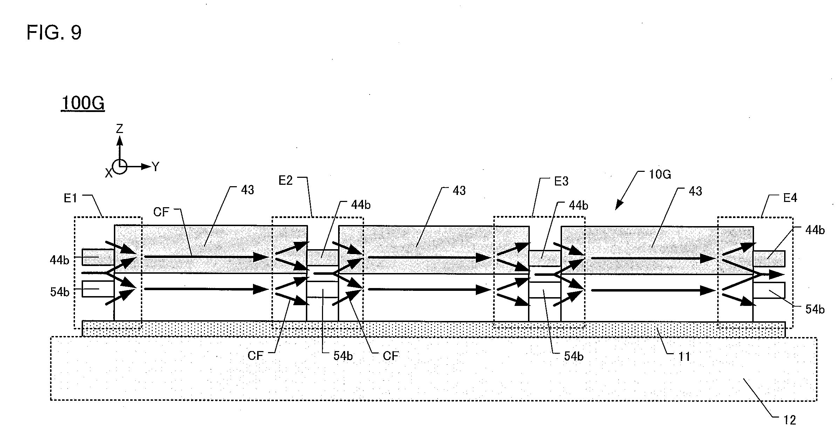

FIG. 9 is a side view of the seventh heat sink 100G in the seventh embodiment viewed from the -X-axis direction. In FIG. 9, the bold arrows represent the flow direction of the cooling fluid CF. The cooling fluid CF flows along the +Y-axis direction.

First, as shown in the dotted line E1 in FIG. 9, since the frame portion 44b in the X-axis direction and the frame portion 54b in the X-axis direction are separated from the base plate portion 11 in the Z-axis direction, the cooling fluid CF flowing inside the seventh heat sink 100G collides with the frame portion 44b in the X-axis direction and the frame portion 54b in the X-axis direction, which causes turbulence.

Then between two louvers 43, turbulent cooling fluid CF becomes laminar flow. At the dotted line E2, the cooling fluid CF becomes turbulent due to the presence of the frame portions 44b and 54b in the X-axis direction. Specifically, laminar flow between two louvers 43 collides with the frame portion 44b and 54b in the X-axis direction, and separates in both Z-axis directions of the frame portions 44b and 54b in the X-axis direction. Thus, the cooling fluid CF separates to both sides of the frame portion 44b and 54b in the X-axis direction, and flows upward and downward as turbulent flow.

Similar with the dotted line E2, at the dotted line E3, the cooling fluid CF becomes turbulent due to the presence of the frame portions 44b and 54b in the X-axis direction. Finally, at the dotted line E4, the cooling fluid CF is separated in both Z-axis directions of the frame portions 44b and 54b, thus becomes turbulent at frame portions 44b and 54b in the X-axis directions. Then, cooling fluid is released from the +Y-axis direction of the seventh heat sink 100G.

As mentioned above, the cooling fluid CF entered into the seventh heat sink 100G from the -Y-axis direction becomes turbulent inside the first heat sink 100G several times, which facilitates heat-exchange with the louver 43 or the base plate portion 11. Thus, heat transfer between the heat generating device 12 and the cooling fluid CF increases, and heat dissipation increases.

By stacking together the respective louvers 43a and the respective louvers 43b and bonding the respective edges using filler, the front surface of the louvers 43 can be made larger, and provides improved heat transfer. Also, the frame portion 44b in the X-axis direction and the frame portion 54b in the X-axis direction can cause turbulence. For example, height of the louvers can be altered accordingly. Such alternations do not cause major change in productivity, since this embodiment can be accomplished by assembling together two edges of respective louvers.

### EIGHTH EMBODIMENT

### <Configuration of the Third Heat Sink 100H>

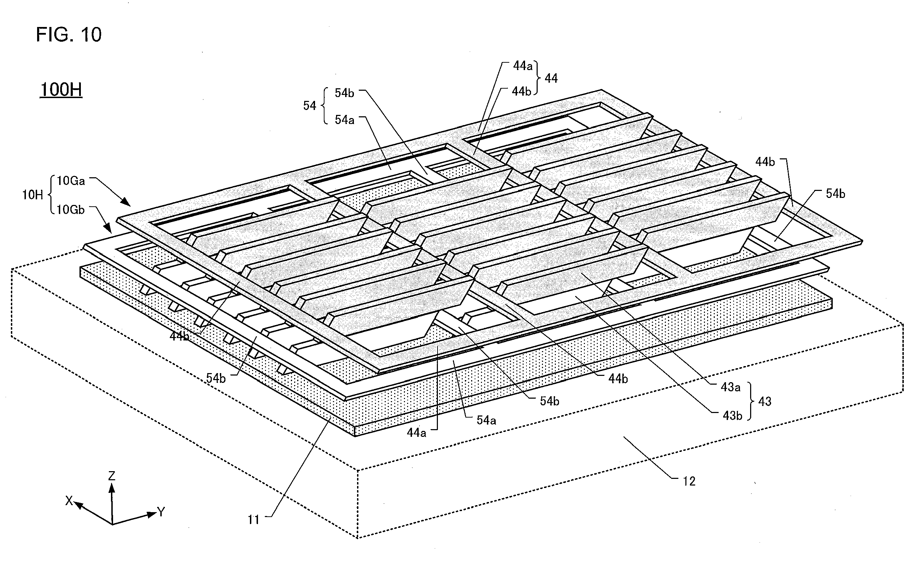

FIG. 10 is a schematic view of an eight heat sink 100H in the eighth embodiment.

In the eighth embodiment, the eighth fin unit 10H is a duplex fin unit constituted of a first fin portion 10Ga and a second fin portion 10Gb, which was explained also in the seventh embodiment.

As shown in FIG. 10, the eighth fin unit 10H are formed by bonding the first fin portion 10Ga and the second fin portion 10Gb thermally bonded at the edge portion of the louver 43a and the edge portion of the louver 43b, and one edge of the louver 43a and 43b are separated in the Y-axis direction. Here, the width of the new louver constituted of stacking together louvers 43a and 43b is denoted as width D, the distance between louvers in the X-axis direction is D/2 and its thickness becomes T₁.

### <Cooling by Using the Eighth Heat Sink 100H>

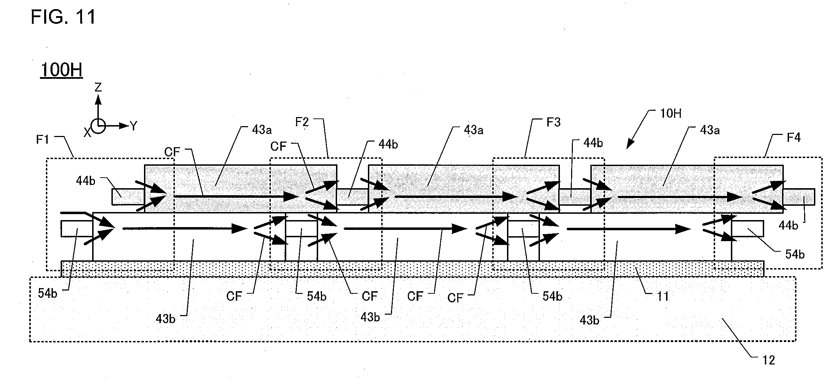

FIG. 11 is a side view of the eighth heat sink 100H in the eighth embodiment viewed from the -X-axis direction. In FIG. 11, the arrows represent the flow direction of the cooling fluid CF. The cooling fluid CF flows along the +Y-axis direction.

First, as shown in the dotted line F1 in FIG. 11, since the frame portion 54b in the X-axis direction of the eighth fin unit 10H is apart from the base plate portion 11 in the Z-axis direction, the cooling fluid CF flowing inside the eighth heat sink 100H collides with the frame portion 54b in the X-axis direction, and thus causes turbulence. Then, after the separated cooling fluid CF flows through the frame portion 54b in the X-axis direction, the cooling fluid CF flowing inside the eighth heat sink 100H collides with the frame portion 44b in the X-axis direction and causes turbulence, frame portion 44b in the X-axis direction is separated from the base plate portion 11 in the Z-axis direction.

The, the cooling fluid CF flowing between the louvers 43 becomes laminar airflow and flows toward the +Y-axis direction. Then airflow becomes turbulent at the frame portion 54b indicated in the dotted line F2, and at the downstream thereof by the frame portion 44b in the X-axis direction.

Similarly with the dotted line F2, the cooling fluid CF becomes turbulent at the position surrounded by the dotted line F3 by the frame portion 54b in the X-axis direction, and the turbulence is formed at the frame portion 44b in the X-axis direction. Finally, cooling fluid CF collides with the frame portion 54b in the Z-axis direction, and separates in both Z-axis directions of the frame portions 44b and 54b in the X-axis direction. Then, the cooling fluid CF is released from the +Y-axis direction of the eighth heat sink 100H.

As indicated above, the cooling fluid CF entered from the eighth heat sink 100H from the -Y-axis direction becomes turbulent inside the eighth heat sink 100H, and facilitates heat-exchange with the louvers 43 or the base plate portions 11. This increases heat transfer between the heat generating device 12 and the cooling fluid CF, and increases heat dissipation.

### NINTH EMBODIMENT

### <Configuration of the Third Heat Sink 100J>

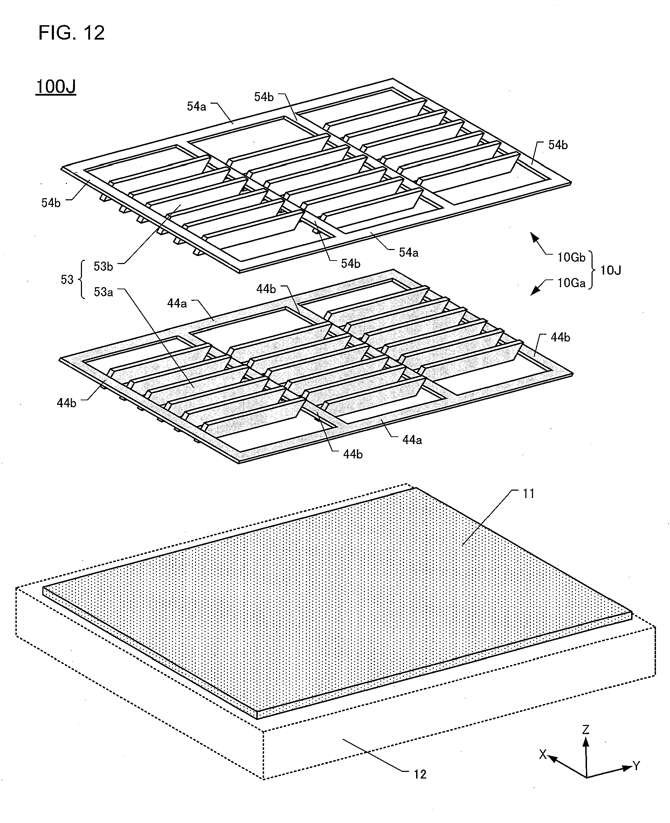

FIG. 12 is a schematic view of the ninth heat sink 100J in the ninth embodiment. In the ninth embodiment, the ninth fin unit 10J is a duplex fin unit constituted of a first fin portion 10Ga and a second fin portion 10Gb explained In the seventh embodiment.

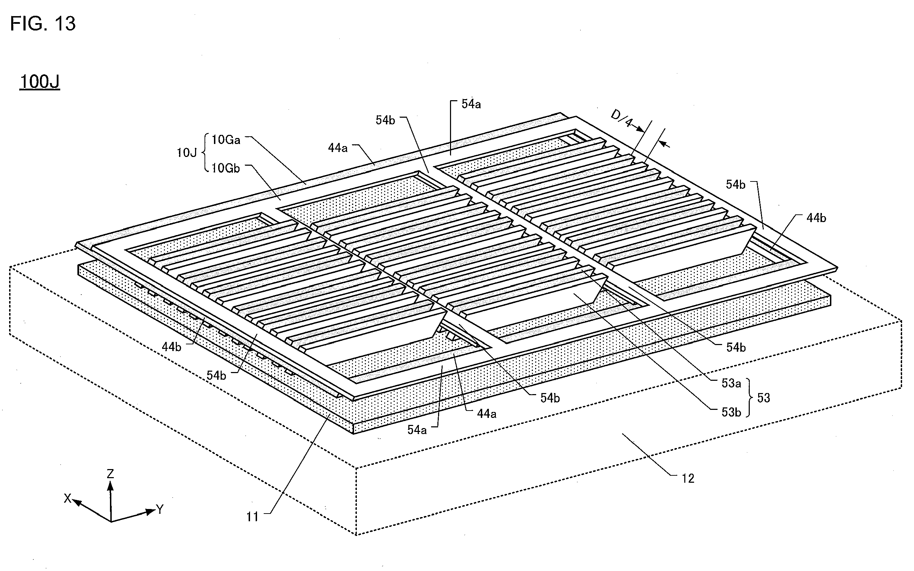

As shown in FIG. 12, the first fin unit 10Ga and the second fin unit 10Gb are stacked together by situating the second fin portion 10Gb and the first fin portion 10Ga off-set by distance D/4 in the X-axis direction. FIG. 13 is a schematic view of the ninth heat sink 100J after assembling together the first fin unit 10Ga and the second fin unit 10Gb.

As shown in FIG. 13, the first fin unit 10Ga and the second fin unit 10Gb are not bonded together by bonding together the louvers 53a and 53b, rather they are off-set by D/4 in the X-axis direction. Thus, the louvers 53a on the first fin unit 10Ga is inserted to the louvers 53b on the second fin unit 10Gb, and the louvers 53b on the second fin unit 10Gb is inserted to the louver 53a on first fin unit 10Ga. The respective -Z-axis edge portions of the louvers 53a and 53b inserted with each other is bonded to the base plate portion 11 by filler.

In order to contact the -Z-axis edge portions of the louvers 53a and 53b to the base plate portion 11, the louvers 53b should be formed longer in the -Z-axis direction than the louvers 53a. This is because the frame portion 54 of the second fin portion 10Gb is situated above the frame portion 44 of the first fin portion 10Ga. Therefore, the position for connecting the frame portions 54b in the X-axis direction and the louvers 53b can be situated slightly above the center of the width direction of the louvers 53b in the Z-axis direction.

As an alternative method, only the edge portion of the louvers 53a can be connected to the base plate portion 11. Since the frame portions 44 of the first fin portion 10Ga and the frame portions 54 of the second fin portion 10Gb are bonded together, heat from the base plate portion 11 transfers to the louvers 53a, and the heat from the louver 53a transfers to the frame portions 44 and 54, and finally transfers to the louvers 53b.

According to the configuration in the ninth embodiment, the distance between two louvers 53a and 53b in the ninth fin unit 10J is D/4, which makes the distance in the X-axis direction narrower. Thus, the density of the louvers 53 becomes higher, and thus increases cooling performance of the ninth heat sink 100J.

### TENTH EMBODIMENT

### <Configuration of the Third Heat Sink 100K>

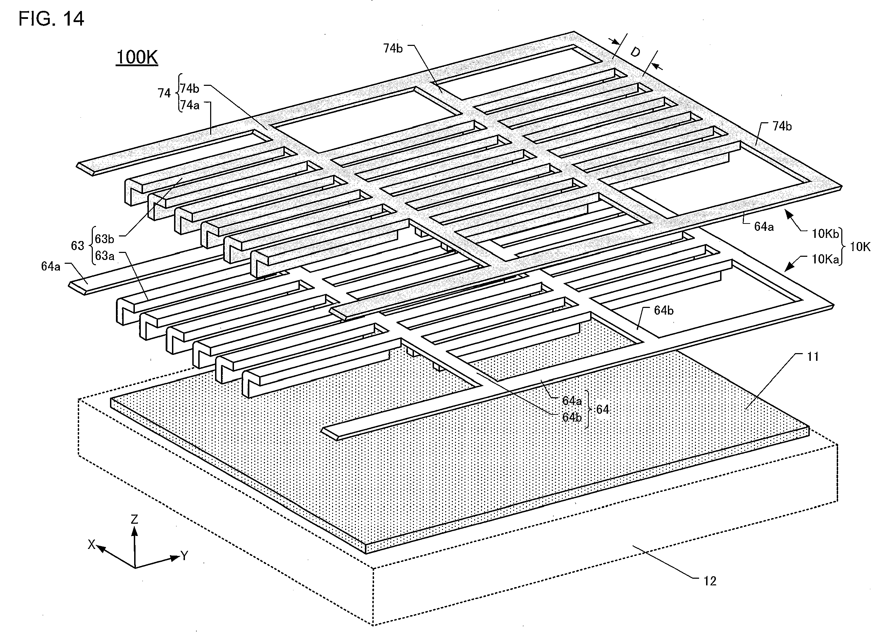

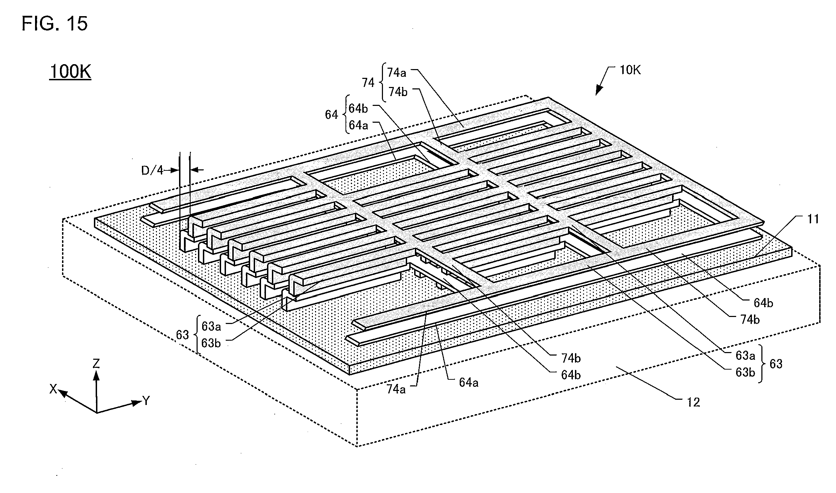

FIG. 14 is an exploded perspective view of a tenth heat sink 100K in the tenth embodiment. FIG. 15 is a schematic view of a tenth heat sink 100K after assembling together the first fin unit 10Ka and second fin unit 10Kb. To provide better understanding, in FIGS. 14 and 15, the left side (-Y-axis side) of the frame portion 64b and 74b in the X-axis direction are omitted from the drawing.

The tenth heat sink 100K comprises a tenth fin unit 10K. The tenth fin unit 10K comprises a first fin unit 10Ka and a second fin unit 10Kb. The first fin portion 10Ka comprises a plurality of louvers 63a fabricated by cutting and forming a part of the metal plate, and the frame portions 64 connected to the plurality of louvers 63a and supports thereof. The second fin portion 10Kb comprises a plurality of louvers 63b and the frame portions 74 connected to the plurality of louvers 63b and supports thereof. Also, the frame portions 64 comprises the frame portions 64a in the Y-axis direction and the frame portions 64b in the X-axis direction, and the frame portions 74 comprises the frame portions 74a in the Y-axis direction and the frame portions 74b in the X-axis direction.

A part of the louvers 63a (D/2 portion in the X-axis direction) is a planar surface as the frame portion 64, and the remaining portion of the louvers is bent at 90-degree angle. The angle θ of the remaining louvers 63a and 63b can be set at arbitrary angle between 10-degrees to 90-degrees. Also, as shown in FIG. 14, the adjacent rows of louvers 63 are situated D/2 distance apart in the X-axis direction from each other.

As shown in FIG. 15, the first fin portion 10Ka and the second fin portion 10Kb are stacked together by situating the second fin portion 10Kb and the first fin portion 10Ka by distance D/4.

As shown in FIG. 15, when stacking together the first fin portion 10Ka and the second fin portion 10Kb, the louvers 63a and 63b are situated at the distance D/4 apart. Thus, the edge portion of the bent louvers 63b is bonded to the same planar surface as the frame portion 64 of the louvers 63a by using filler. Although the louvers 63a and 63b are off-set by the distance D/4 in FIG. 15, it does not always need to be off-set in the X-axis direction.

According to the tenth embodiment, the louvers 63a and 63b are configured as bent. Instead of bending at straight angle, louvers can be bent as curved. Bending in a curved manner does not cause torsional deformation at the connecting portion, and allows the shape of the louver to be formed in a relatively accurate dimension.

### ELEVENTH EMBODIMENT

### <Configuration of the Third Heat Sink 100L>

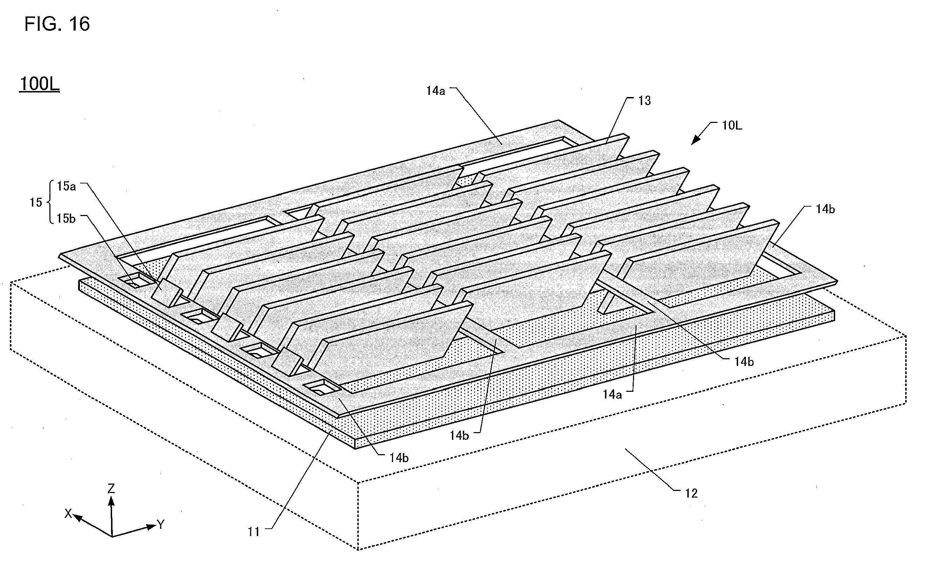

FIG. 16 is a schematic view of the eleventh heat sink 100L in an eleventh embodiment.

Comparing to the first heat sink 100A in the first embodiment, the eleventh heat sink 100L in the eleventh embodiment comprises a plurality of flow-channel changing portions 15 on the frame portion 14b in the X-axis direction on the -Y-side. Other configurations in this embodiment are similar to the first heat sink 100A in the first embodiment, and explanations regarding other components are omitted.

As shown in FIG. 16, the flow-channel changing portions 15 comprise the upstream flow-channel changing portions 15a and the downstream flow-channel changing portions 15b. The upstream flow-channel changing portions 15a and the downstream-channel changing portions 15b are located at each pair of louvers 13 along the X-axis direction. Also, although three upstream flow-channel changing portions 15a and four downstream flow-channel changing portions 15b are drawn on the eleventh heat sink 100L, it can be added or deleted depending on the number of the louvers 13.

### <Cooling Using the Eleventh Heat Sink 100L>

A cooling method using the eleventh heat sink 100L is explained using the upstream flow-channel changing portion 15a as a reference.

FIG. 17A is a side view of the eleventh heat sink 100L in the eleventh embodiment. FIG. 17A includes an upstream flow-channel changing portion 15a. FIG. 17B is an exploded view of the dashed line G in FIG. 17A. In FIG. 17, the arrows represent the flow direction of the cooling fluid CF. The cooling fluid CF flows along the +Y-axis direction.

As shown in FIG. 17A, the upstream flow-channel changing portion 15a is situated on the frame portion 14b in the X-axis direction, and this causes turbulence in the area indicated in the dashed line G. Turbulences occurring at three frame portions 14b in the X-axis direction are the same as in the first embodiment, and explanations are omitted. Hereinafter, the area encircled by the dashed line G in FIG. 17A is explained using FIG. 17B as reference.

As shown in FIG. 17B, cooling fluid CF entered from the -Y-axis direction to the eleventh fin unit 10L becomes turbulent at the dashed line H1. Specifically, cooling fluid CF entered into the eleventh fin unit 10L from the +Z-axis direction of the frame portion 14b in the X-axis direction collides with the upstream flow-channel changing portion 15a situated on the frame portion 14b in the X-axis direction, then flows diagonally relative to the +Z-axis direction, and thus becomes turbulent.

On the other hand, cooling fluid CF entered from the -Z-axis direction of the frame portion 14b in the X-axis direction into the eleventh fin unit 10L enters into a hole 16 fabricated by cutting and forming the upstream flow-channel changing portion 15a. The hole 16 causes the stream to flow diagonally relative to the +Z-axis direction, and thus causes turbulence of the cooling fluid CF.

In the downstream flow-channel changing portion 15b (see FIG. 16), the cooling fluid CF flows toward the opposite direction from the flow direction explained previously with respect to flow-channel changing portion 15a, and thus becomes turbulent. In the flow-channel changing portion 15, the upstream flow-channel changing portion 15a and the downstream flow-channel changing portion 15b can be cut individually, as explained in this embodiment. Or, it can be used to apply the cooling medium onto a part of the heat generating device and cool the most heated position in a focused way.

Although the flow-channel changing portion 15 is situated at the frame portion 14b of the X-axis frame portion on the -Y-axis upstream portion, it can be situated at the frame portion 14b in the X-axis direction of the downstream portion.

Also, by situating a flow-channel changing portion 15 in the frame portion 14 in the X-axis direction, turbulence occurs more frequently and thus facilitates heat-exchange. Therefore, cooling fluid CF entered into the eleventh heat sink 100L becomes turbulent inside the eleventh heat sink 100L and facilitates heat-exchange with the louvers 13 or the base plate portion 11.

### TWEFLTH EMBODIMENT

### <Configuration of the Third Heat Sink 100M>

FIG. 18 is a schematic view of a twelfth heat sink 100M in the twelfth embodiment. In the twelfth embodiment, liquid such as water and antifreeze is used as cooling fluid CF. Whenever the cooling fluid CF is liquid, a cover plate is required, so that the cooling fluid CF flows inside the tube.

Comparing to the first heat sink 100A in the first embodiment, the twelfth heat sink 100M in the twelfth embodiment comprises a cover plate 17 for covering the outer periphery, so as to prevent liquid cooling fluid CF in the twelfth heat sink 100M from leaking toward the +Z-axis direction of the twelfth fin unit 10L. Here, the cover plate 17 is drawn with a dashed line, so that the twelfth fin unit 10L can be seen transparent. Other configurations are the same as the first heat sink 100A in the first embodiment, and explanations are omitted.

When liquid is used as cooling fluid, thicker louvers 13 are suggested, since liquid provides better heat dissipation than air or gas and hampers in providing heat toward tips of the louvers. In the present invention, thicker louvers can be placed in a smaller pitch, since it can be solved by making the stamping plate thicker.

In the twelfth embodiment, the cover plate 17 is fabricated by stamping one plate of metal material having excellent heat transfer, such as aluminum, copper or alloy thereof, and thickness of the metal plate T₂ is approximately 0.8mm. Although not shown in the drawings, the second to eleventh embodiments can be replaced with liquid cooling fluid CF having a cover plate 17 mounted onto the heat sink.

### THIRTEENTH EMBODIMENT

### <Configuration of the Third Heat Sink 100N>

FIG. 19A is a schematic view of the thirteenth heat sink 100N in the thirteenth embodiment, and a cover plate 17 is drawn as transparent and with dotted line, so that the thirteenth fin unit 10N can be viewed. FIG. 19B is a side view of the thirteenth heat sink 100N in the thirteenth embodiment viewed from the -X-axis direction. In FIG. 19B, the cover plate 17 is omitted from the drawing.

As shown in FIG. 19A, the thirteenth fin unit 10N is constituted of one metal plate, and the metal plate forms a plurality of louvers 83 that are cut and formed diagonally along the -Z-axis direction relative to the metal plate and a frame portion 84, connected to the plurality of louvers 83, which are not cut and remains. Also, the frame portion 84 comprises a frame portion 84a in the Y-axis direction and a frame portion 84b in the X-axis direction. Also, the frame portion 84b in the X-axis direction is connected to one edge of the louvers 83 in the +Z-axis direction. Other configurations, such as the angle θ and the width D, are the same as the first fin unit 10A.

The thirteenth fin unit 10N in FIG. 19 can be fabricated as one unit by stamping one metal plate and thus reduces manufacturing cost. Also, since the fin unit 10N is connected to the frame portion 84 and formed as one unit, it can be handled and assembled easily. Furthermore, the fin unit 10N of the thirteenth embodiment can be accomplished by changing the shape of the mold for stamping and changing the position of the frame portion 84. Thus it does not require a major cost increase.

The cover plate 17, which was described in the twelfth embodiment, is situated at a position facing the base plate portion 11 and so as to constitute a wall of the flow channel of the cooling fluid CF in the +Z-axis direction of the thirteenth fin unit 10N. The thirteenth fin unit 10N is situated between the cover plate 17 and the base plate portion 11. The frame portion 84 is connected to the cover plate 17 in cohesive manner. Since the position of the cover plate 17 is situated away from the mainstream of the cooling fluid CF, dusts present inside the cooling fluid CF is unlikely to be trapped into the frame portion.

Also, as shown in dotted lines J1 to J4 in FIG. 19B, cooling performance can be increased by changing the flow direction of the cooling fluid CF toward the opposite direction of the frame portion 84 and closer to the base plate portion 11, which allows direct cooling of the base plate portion 11. The cooling performance can be made more efficient by making the position of the frame portion 84 so that the cooling fluid CF flows directly toward the heat generating device 12 where the temperature is a greatest.

### FOURTEENTH EMBODIMENT

### <Configuration of the Third Heat Sink 100P>

FIG. 20A is a side view of a fourteenth heat sink 100P in the fourteenth embodiment viewed from the -Y-axis direction. Although not drawn, a cover plate 17 is situated on top of the fourteenth heat sink 100P in the +Z-axis direction. To provide a better understanding, the heat generating device 22 is drawn; however it does not constitute a part of the fourteenth heat sink 100P. In the fourteenth embodiment, the heat generating device 22 comprises a stepwise portion 22a (this can be either protruding surface or recessed surface) in the center of the planar portion 22b. The heat generating device 22 having stepwise portion comprises a stepwise portion 21 a and a planar portion 21 b in the center of the base plate portion 21. The stepwise portion is configured so as to efficiently release heat by creating larger contacting area between the base plate portion 21 and the heat generating device 22. The louvers are preferred to be adjusted to the stepwise portion 21a and the planar portion 21 b of the base plate portion 21.

As shown in FIG. 20A, the fourteenth fin unit 10P in the fourteenth embodiment is constituted of two types of louvers: louvers 83A and louvers 83B. The louvers 83A have the same shape as the louvers 83 of the thirteenth fin unit 10N described in the thirteenth embodiment. The louver 83A is angled at θ degrees, and connected to the planar portion 21 b of the base plate portion 21 by using filler, for example. The louvers 83B, which have same shape as the louvers 83A, is mounted onto the stepwise portion 21a of the base plate portion 21 at angle ϕ (wherein ϕ is smaller than θ) by using filler. Thus, all louvers 83A and 83B are thermally connected to the base plate portion 21. There can be numerous height differences between the stepwise portion 21 a and the planar portion 21 b of the base plate portion 21, and the louvers 83B and 83B can be adjusted to an appropriate angle. By fabricating a plurality of heat dissipating fins on one fin unit, heat transfer and circulation resistance to the cooling medium can be adjusted on a part basis.

Also, the fourteenth fin unit 10P in the fourteenth embodiment does not require a major cost increase, since such changes can be accomplished by changing the shape of the mold for stamping, and changing the angle of the louvers so that it matched to the stepwise portion 21 a and the planar portion 21 b of the base plate portion 21. Also, in this method, even if the formation of the heat sink differs, a fin unit can be fabricated by preparing several fin units having a basic shape and assembling appropriate fin units. Since the mold is not necessary to be manufactured at a product basis, the cost of production can be reduced.

Also, although the fourteenth embodiment was explained using one fin unit, it can be replaced with a plurality of fin units combined together by cutting along the cut line CL, as denoted with dotted-dashed line in FIG. 20A.

### (Alternative to Fourteenth Embodiment)

### <Configuration of the Fourteenth Heat Sink 100P'>

FIG. 20B is a side view of the fourteenth heat sink 100P' which is an alternative to the fourteenth embodiment, as viewed from the -Y-axis direction. In the alternative to the fourteenth embodiment, the heat generating device 22 comprises a stepwise portion 22a in the center of the planar portion 22b. The heat generating device 22 having stepwise portion comprises a stepwise portion 21 a and a planar portion 21 b in the center of the base plate portion 21.

As shown in FIG. 20B, the fourteenth heat sink 100P' in the fourteenth embodiment is constituted of two types of louvers: louvers 83A and louvers 83C. In the alternative to the fourteenth embodiment, the louvers 83C are shorter than the louvers 83A, angled at θ degrees and connected to the planar portion 21 b of the base plate portion 21 by using filler, for example. Thus, all louvers 83A and 83C are thermally connected to the protruding base plate portion 21. By fabricating a plurality of heat dissipating fins on one fin unit, heat transfer and circulation resistance to the cooling medium can be adjusted on a part basis.

Whenever the height between louvers differs and the base plate is flat, louvers with lower height cannot be connected. However, by situating stepwise portions, louvers can be thermally bonded even if the fin units having different heights are present.

Also, although the fourteenth embodiment was explained using one fin unit, it can be a plurality of fin units combined together by cutting along the cut line CL, as denoted with dotted-dashed line in FIG. 20B. Also, since the louvers 83A and 83C are fabricated by stamping one metal plate, the distance between the respective louvers 83C can be formed narrower than the distance between respective louvers 83A.

### FIFTEENTH EMBODIMENT

### <Configuration of the Third Heat Sink 100Q>

FIG. 20C is a schematic view of a fifteenth heat sink 100Q in the fifteenth embodiment. Although not drawn, a cover plate 17 is situated on top of the fifteenth heat sink 100Q in the +Z-axis direction. As drawn in FIG. 20C, the fifteenth heat sink 100Q comprises a fifteenth fin unit 10Q fabricated by assembling the louvers 83D and louvers 83E that have different length than the louvers 83D.

In the fifteenth fin unit 10Q, the length L2 of the louvers 83E in the Y-axis direction is twice the length of the length L1 of the louvers 83D. By adjusting the position of the frame portions 84b in the Y-axis direction where turbulence of the cooling fluid CF occurs, a partial heat transfer and fluid resistance of the cooling fluid CF can be adjusted. Thus, by providing two types of louvers 83E and 83D having different length, cooling efficiency at a specific portion can be adjusted.

Also, although the fifteenth embodiment was explained using one fin unit, it can be replaced with a plurality of fin units combined together by cutting along the cut line CL, as denoted with dotted-dashed line in FIG. 20C.

### SIXTEENTH EMBODIMENT

### <Configuration of the Third Heat Sink 100R>

FIG. 21 is an exploded perspective view of a sixteenth heat sink 100R in the sixteenth embodiment; FIG. 22 is a schematic view of a sixteenth heat sink 100R in the sixteenth embodiment; and FIG. 23 is a side view of the sixteenth heat sink 100R in the sixteenth embodiment viewed from the -X-axis direction. Although not drawn, a cover plate 17 is situated on top of the fourteenth heat sink 100R in the +Z-axis direction.

As shown in FIG. 21, the sixteenth fin unit 10R is a duplex fin unit constituted of a first fin unit 10Ra and a second fin unit 10Rb. Here, the first fin unit 10Ra and the second fin unit 10Rb have same shape as the thirteenth fin unit 10N explained in the thirteenth embodiment. However, length of the louvers 93a of the first fin unit 10Ra and the louvers 93b of the second fin unit 10Rb in the short-edge direction is approximately a half (D/2) of the length of the louvers 83 in the thirteenth fin unit 10N in the short-edge direction.

Therefore, as shown in FIG. 22, the length of the louvers 93 in the short-edge direction formed by stacking together the first fin unit 10Ra and the second fin unit 10Rb equals to the length D of the louvers 83 of the first fin unit 10N in the short-edge direction.

Here, in the sixteenth fin unit 10R fabricated by stacking a plurality of fin portions 10Ra and 10Rb together, the area of the louvers can be made larger by thermally connecting tips of the respective louvers by using filler, and this also provides improved heat transfer.

Also, as shown in the dotted lines K1 to K4 in FIG. 23, the frame portions 94 and 104 of the respective fin portions 10Ra and 10Rb are situated on the opposing side of the base plate portions 11. Thus, the flow direction of the cooling fluid CF changes toward the opposing direction to the frame portions 94 and 104, and flows closer to the base plate portion 11, which allows cooling directly to the base plate portion 11 and thus provides improved heat transfer. Furthermore, the sixteenth fin unit 10R can be fabricated by assembling a plurality of fin portions 10Ra and 10Rb, which does not require a significant amount of work. Furthermore, there can more than two fin portions for stacking together.

### SEVENTEENTH EMBODIMENT

### <Configuration of the Third Heat Sink 100S>

FIG. 24 is an exploded perspective view of the seventeenth heat sink 100S in the seventeenth embodiment; FIG. 25 is a schematic view of the seventeenth heat sink 100S in the seventeenth embodiment; and FIG. 26 is a side view of the seventeenth heat sink 100S in the seventeenth embodiment as viewed from the -X-axis direction. Although not drawn, a cover plate 17 is situated on top of the seventeenth heat sink 100S in the +Z-axis direction.

As shown in FIG. 24, the seventeenth fin unit 10S is a multiple fin unit constituted of a first fin unit 10Sa and a second fin unit 10Sb. Here, the first fin unit 10Sa has the same shape as the thirteenth heat sink 100N explained in the thirteenth embodiment. Also, the second fin portion 10Sb is formed by displacing the frame portion 124 from the +Z-axis direction of the louvers 103b to the -Z-axis direction. The amount of displacement is preferred to be approximately T1 thickness of the frame portion 114. Furthermore, since the first fin portion 10Sa and the second fin portion 10Sb are fabricated by stamping one metal plate, the distance between the louvers 103a and 103b is the same as the length D between the louvers 103a and 103b in the short-edge direction.

As shown in FIG. 25, the first fin unit 10Sa and the second fin unit 10Sb are stacked together by situating the second fin unit 10Sb and the first fin unit 10Sa off-set by D/4 in the X-axis direction. Thus, the louvers 103a on the first fin portion 10Sa is inserted to the louvers 103b on the second fin unit 10Sb, and the louvers 103b on the second fin portion 10Sb is inserted to the louver 103a on first fin unit 10Sa. The respective -Z-axis edge portions of the louvers 103a and 103b inserted with each other is bonded to the base plate portion 11 by filler.

According to the configuration in the seventeenth embodiment, the distance of two louvers 103a and 103b in the seventeenth fin unit 10S is D/4, which makes the distance in the X-axis direction narrower. Thus, by situating a plurality of fin portions 10Sa and 10Sb so as to place the respective louvers 103a and 103b in alternating manner, the pitch of fin can be made smaller without changing height of the louvers 103 and increase the density of the fins, and improves heat transfer.

As shown in the dotted lines S1 to S4 in FIG. 26, the frame portions 114 and 124 are connected in cohesive manner at the positions where the frame portions 114 and 124 of the plurality of fin portions 10Sa and 10Sb are stacked together (see cover plate 17 in the thirteenth embodiment). Also, a wall of flow channel is situated at a position facing the base plate portion 11, the seventeenth fin unit 10S is situated between the base plate portion 11 and the wall of flow channel, the wall of flow channel constitutes the flow channel of the cooling fluid, and the frame portion is connected to the wall of flow channel in coherent manner. Such alternations do not cause major change in productivity, since this embodiment can be accomplished by assembling together two edges of respective louvers.

### EIGHTEENTH EMBODIMENT

### <Configuration of the Third Heat Sink 100T>

FIG. 27 is a schematic view of an eighteenth heat sink 100T in the eighteenth embodiment, and FIG. 28 is a side view of an eighteenth heat sink 100T in the eighteenth embodiment viewed from the -X-axis direction. Although not drawn, a cover plate 17 is situated on top of the eighteenth heat sink 100T in the +Z-axis direction.

As shown in FIG. 27, the eighteenth fin unit 10T is a duplex fin unit constituted of a first fin portion 10Ta and a second fin portion 10Tb. Here, the first fin unit 10Ta and the second fin unit 10Tb have same shape as the first fin portion 10Ra and the second fin portion 10Rb in the sixteenth embodiment. However, the first fin portion 10Ta and the second fin portion 10Tb are off-set in the Y-axis direction.

As shown in dotted lines M1 to M4 in FIG. 28, by situating the respective frame portions 134 and 144 of the first fin portion 10Ta and the second fin portion 10Tb stacked together in forward or backward directions of the flow direction, the cooling fluid CF flows closer to the base plate portion 11. This allows cooling the heat generating device directly, and improved heat transfer.

Although the flow channel wall is not drawn in the heat sink of fourteenth to eighteenth embodiments, a cover plate 17 used in the thirteenth embodiment is situated as the flow channel wall. Also, the flow-channel changing portions 15 explained in the eleventh embodiment can be applied to the thirteenth to eighteenth embodiments.

### <Configuration of Bonding the Louvers and the Base Plate Portion>

In the first to eighteenth embodiments described above, the fin unit is bonded to the base plate portion via louvers, while the frame portions and the base plate portion are situated apart in the Z-axis direction. This is because, whenever the frame portions and the base plate portion are connected by contacting the respective principal surfaces, the frame portions and the base plate portion may not be able to be thermally contacted due to the presence of bubbles. However, when the fin unit is connected to the base plate portion by contacting the tip of louvers onto the base plate portions, bubbles are unlikely to remain onto the surface thereof.

FIG. 29 is a drawing of a louver contacting the base plate portion. FIG. 29A is a drawing explaining the louvers 13 bonded to the base plate portion 11 diagonally by using filler in the previous first to eighteenth embodiments.

As shown in FIG. 29A, by mounting the louver 13 onto the base plate portion 11 at the angle θ by using filler 18, the louver 13 is contacted diagonally to the base plate portion 11 at an edge K, and no bubble enters while bonding. Therefore, the louver 13 can be bonded to the base plate portion 11 without failure. Also, thermal bonding can be accomplished by placing filler material 18 and heating thereof; however by using a brazing sheet as a part of the material, assembling before thermal bonding can be accomplished more easily, since the filler material 18 is cladded onto the brazing sheet.

FIG. 29B is a drawing explaining the louvers 13C and 13F bonded to the base plate portions 11 and 21 perpendicularly by using filler in the previous third and fourth embodiments.

As shown in FIG. 29B and explained in FIG. 19A, the louvers 13C and 13F are bonded to the base plate portion 11 by using filler material 18 without failure. In some situation, the louvers 13C and 13F may trap bubbles into the filler material, such as air, while bonding using filler. Bubbles should be avoided from entering into the filler material 18, since bubbles hinder heat transfer.

FIG. 29C is a drawing explaining the louver 13 bonded to the base plate portion 11 by swaged portion 19 in the previous first to eighteenth embodiments. In FIG. 29C, in order to facilitate heat dissipation rate, a swaged portion 19 is situated on the base plate portion 11, and the louver is connected by using the swaged portion 19. Thus, a groove portion 20 is situated in the base plate portion 11, and each louver 13 is inserted into the groove portion 20. Here, the louver 13 is inserted into the base plate portion 11 so as to form the angle θ between the louver 13 and the base plate portion 11. Then the louver 13 is swaged to the -X-axis direction by using the swaged portion 19 situated on the base plate portion 11. Such configuration allows larger connecting area between the louver 13 and the swaged portion 19 of the base plate portion 11, and thus facilitates heat-exchange. Such heat exchange improves heat transfer and heat dissipation of the heat generating device.

### INDUSTRIAL APPLICABILITY

Representative embodiments have been described in detail above. As evident to those skilled in the art, the present invention may be changed or modified in various ways within the technical scope of the invention.

## Claims

1. A heat sink which transfers heat dissipated from a heat generating device (12) to a cooling fluid (CF), said heat sink comprises:
a base plate portion (11) formed in a planar manner and that is thermally connected to said heat generating device; and
a fin unit (10A) having a plurality of louvers (13) and a frame portion (14) that connects to said plurality of louvers and surrounds thereof;
wherein one edge of said plurality of louvers is thermally connected to said base plate portion; and
said frame portion is situated apart from a principal surface of said base plate portion.

2. The heat sink of claim 1, wherein at least a part of said plurality of louvers is fabricated by cutting and forming from one metal plate, and said frame portion is fabricated by a portion of said metal plate that is not cut and formed.

3. The heat sink of claim 1, wherein said plurality of louvers has a distance extending parallel to a flowing direction of said cooling fluid and a width for cutting and forming said louvers and angle for forming louvers;
wherein at least several louvers from said plurality of louvers have different figure in at least one figure selected from a different length, a different width or a different cutting angle.

4. The heat sink of claim 1, wherein said fin unit comprises a first fin unit fabricated by stamping one metal plate, and a second fin unit fabricated stamping another metal plate;
wherein said louvers of said first fin unit differs from said louvers of said second fin unit in at least one figure selected from a different length, a different width or a different cutting angle.

5. The heat sink of claim 1, wherein said fin unit comprises a first fin unit fabricated by stamping one metal plate, and a second fin unit fabricated stamping another metal plate;
wherein one edge portion of said louvers of said first fin unit is thermally connected to said base plate portion, and one edge portion of said louvers of said second fin unit is thermally connected to said other edge portion of the louvers of said first fin unit.

6. The heat sink of claim 5, wherein said frame portion of said first fin unit and said frame portion of said second fin unit are situated apart from each other.

7. The heat sink of claim 5, wherein said frame portion of said first fin unit and said frame portion of said second fin unit are connected with each other.

8. The heat sink of claim 2 or claim 3, wherein said fin unit comprises a first fin unit fabricated by stamping one metal plate and a second fin unit fabricated by stamping another metal plate;
wherein a plurality of louvers of said first fin unit is situated between a plurality of louvers of the second fin unit.

9. The heat sink of claim 1, wherein said frame portion comprises a flow-channel changing portion (15) for changing a flowing direction of the cooling fluid.

10. The heat sink of claim 1, wherein said cooling fluid is liquid; and a cover plate connected to said other edge of the plurality of louvers is situated so as to constitute flowing direction of said cooling fluid CF of the liquid.

11. The heat sink of claim 1, wherein said fin unit is fabricated by stamping a metal plate; and said fin unit is mounted onto said base plate by using filler.

12. The heat sink of claim 11, wherein a base material of said metal plate is aluminum and said metal plate is a brazing sheet fabricated by cladding filler onto at least one principal surface.

13. A heat sink which transfers heat dissipated from a heat generating device (12) to a cooling fluid (CF), said heat sink comprises:
a base plate portion (11) formed in a planar manner and that is thermally connected to said heat generating device; and
a fin unit (10A) having a plurality of louvers (13) and a frame portion (14) that connects to said plurality of louvers and surrounds thereof;
wherein one edge of said plurality of louvers is thermally connected to said base plate portion; and
a wall of flowing channel (17) is situated at a position facing said base plate portion, said fin unit is situated between said base plate and said wall of flowing channel, said wall of flowing channel constitutes said flowing channel of said cooling fluid, and said frame portion is connected to said wall of flowing channel in coherent manner.

14. The heat sink of claim 13, wherein at least a part of said plurality of louvers is fabricated by cutting and forming from one metal plate, and said frame portion is fabricated by a portion of said metal plate that is not cut and formed.

15. The heat sink of claim 13, wherein said plurality of louvers has a length extending parallel to a flowing direction of said cooling fluid and a width for cutting and forming said louvers and angle for forming louvers;
wherein at least several louvers from said plurality of louvers have different figure in at least one figure selected from a different length, a different width or a different cutting angle.

16. The heat sink of claim 13, wherein said fin unit comprises a first fin unit fabricated by stamping one metal plate and a second fin unit fabricated by stamping another metal plate;
wherein said louvers of said first fin unit have different figure from said second fin unit in at least one figure selected from a different length, a different width or a different cutting angle.

17. The heat sink of claim 13, wherein said fin unit comprises a first fin unit fabricated by stamping one metal plate, and a second fin unit fabricated stamping another metal plate;
wherein one edge portion of said louvers of the first fin unit is thermally connected to the base plate portion, and one edge portion of said louvers of said second fin unit is thermally connected to said other edge portion of the louvers of said first fin unit.

18. The heat sink of claim 14 or 15, wherein said fin unit comprises a first fin unit fabricated by stamping one metal plate, and a second fin unit fabricated stamping another metal plate;
wherein a plurality of louvers of said first fin unit is situated between a plurality of louvers of said second fin unit.

19. The heat sink of claim 13, wherein said frame portion comprises a flow-channel changing portion (15) for changing a flowing direction of the cooling fluid.

20. The heat sink of claim 13, wherein said cooling fluid is liquid; and a cover plate connected to said other edge of the plurality of louvers is situated so as to constitute flowing direction of said cooling fluid (CF) of the liquid.

21. The heat sink of claim 13, wherein said fin unit is fabricated by stamping a metal plate; and said fin unit is mounted onto said base plate by using filler.

22. The heat sink of claim 21, wherein a base material of said metal plate is aluminum and said metal plate is a brazing sheet fabricated by cladding filler onto at least one principal surface.

## Amended claims

### Amended claims under Art. 19.1 PCT

1. A heat sink which transfers heat dissipated from a heat generating device (12) to a cooling fluid (CF), said heat sink comprises:
a base plate portion (11) formed in a planar manner and that is thermally connected to said heat generating device; and
a fin unit (10A) having a plurality of louvers (13) and a frame portion (14) that connects to and surrounds said plurality of louvers;
wherein one edge of said plurality of said louvers is thermally connected to said base plate portion; and
said frame portion is situated apart from a principal surface of said base plate portion.

2. The heat sink of claim 1, wherein at least a part of said plurality of louvers is fabricated by cutting and forming from one metal plate, and said frame portion is fabricated by a portion of said metal plate that is not cut and formed.

3. The heat sink of claim 1, wherein said plurality of louvers has a length extending parallel to a flow direction of said cooling fluid and a width for cutting and forming said louvers and a cutting angle for forming louvers;
wherein at least several louvers from said plurality of louvers have a different configuration in at least one aspect selected from a different length, a different width or a different angle for cutting and bending.

4. The heat sink of claim 1, wherein said fin unit comprises a first fin unit fabricated by stamping one metal plate, and a second fin unit fabricated by stamping another metal plate;
wherein said louvers of said first fin unit have a different configuration from said louvers of said second fin unit in at least one aspect selected from a different length, a different width or a different angle for cutting and bending.

5. The heat sink of claim 1, wherein said fin unit comprises a first fin unit fabricated by stamping one metal plate, and a second fin unit fabricated by stamping another metal plate;
wherein one edge portion of said louvers of said first fin unit is thermally connected to said base plate portion, and one edge portion of said louvers of said second fin unit is thermally connected to the other edge portion of the louvers of said first fin unit.

6. The heat sink of claim 5, wherein said frame portion of said first fin unit and said frame portion of said second fin unit are situated apart from each other.

7. The heat sink of claim 5, wherein said frame portion of said first fin unit and said frame portion of said second fin unit are connected with each other.

8. The heat sink of claim 2 or claim 3, wherein said fin unit comprises a first fin unit fabricated by stamping one metal plate and a second fin unit fabricated by stamping another metal plate;
wherein a plurality of louvers of said first fin unit is situated between a plurality of louvers of the second fin unit.

9. The heat sink of claim 1, wherein said fin unit is fabricated by stamping one metal plate, said frame portion is cut and formed from said metal plate, and said frame portion comprises a flow changing portion (15) for changing a flowing direction of the cooling fluid.

10. The heat sink of claim 1, wherein said cooling fluid is liquid; and a cover plate connected to the other edge of the plurality of louvers is situated so as to define a flow direction of said cooling fluid.

11. The heat sink of claim 1, wherein said fin unit is fabricated by stamping a metal plate; and said fin unit is mounted onto said base plate by using filler.

12. The heat sink of claim 11, wherein a base material of said metal plate is aluminum and said metal plate is a brazing sheet fabricated by cladding filler onto at least one principal surface of said metal plate.

13. A heat sink which transfers heat dissipated from a heat generating device (12) to a cooling fluid (CF), said heat sink comprises:
a base plate portion (11) formed in a planar manner and that is thermally connected to said heat generating device; and
a fin unit (10A) having a plurality of louvers (13) and a frame portion (14) that connects to and surrounds said plurality of louvers;
wherein one edge of said plurality of louvers is thermally connected to said base plate portion; and
a wall of a flow channel (17) is situated at a position facing said base plate portion, said fin unit is situated between said base plate and said wall of the flow channel, said wall of the flow channel constitutes said flow channel of said cooling fluid, and said frame portion is connected to said wall of flow channel in coherent manner.

14. The heat sink of claim 13, wherein at least a part of said plurality of louvers is fabricated by cutting and forming from one metal plate, and said frame portion is fabricated by a portion of said metal plate that is not cut and formed.

15. The heat sink of claim 13, wherein said plurality of louvers has a length extending parallel to a flow direction of said cooling fluid and a width for cutting and forming said louvers and a cutting angle for forming louvers;
wherein at least several louvers from said plurality of louvers have a different configuration in at least one aspect selected from a different length, a different width or a different angle for cutting and bending.

16. The heat sink of claim 13, wherein said fin unit comprises a first fin unit fabricated by stamping one metal plate and a second fin unit fabricated by stamping another metal plate;
wherein said louvers of said first fin unit have a different configuration from said louvers of said second fin unit in at least one aspect selected from a different length, a different width or a different angle for cutting and bending.

17. The heat sink of claim 13, wherein said fin unit comprises a first fin unit fabricated by stamping one metal plate, and a second fin unit fabricated by stamping another metal plate;
wherein one edge portion of said louvers of the first fin unit is thermally connected to the base plate portion, and one edge portion of said louvers of said second fin unit is thermally connected to the other edge portion of the louvers of said first fin unit.

18. The heat sink of claim 14 or 15, wherein said fin unit comprises a first fin unit fabricated by stamping one metal plate, and a second fin unit fabricated by stamping another metal plate;
wherein a plurality of louvers of said first fin unit is situated between a plurality of louvers of said second fin unit.

19. The heat sink of claim 13, wherein said fin unit is fabricated by stamping one metal plate, said frame portion is cut and formed from said metal plate, and said frame portion comprises a flow changing portion (15) for changing a flow direction of the cooling fluid.

20. The heat sink of claim 13, wherein said cooling fluid is liquid; and a cover plate connected to the other edge of the plurality of louvers is situated so as to define a flow direction of said cooling fluid (CF).

21. The heat sink of claim 13, wherein said fin unit is fabricated by stamping a metal plate; and the fin unit is mounted onto said base plate by using filler.

22. The heat sink of claim 21, wherein a base material of said metal plate is aluminum and said metal plate is a brazing sheet fabricated by cladding filler onto at least one principal surface.
